(19) Europäisches Patentamt
European Patent Office
Office européen des brevets

(11) **EP 4 611 262 A1**

(12) **EUROPEAN PATENT APPLICATION**
published in accordance with Art. 153(4) EPC

(43) Date of publication:
**03.09.2025 Bulletin 2025/36**

(21) Application number: **23944497.9**

(22) Date of filing: **03.07.2023**

(51) International Patent Classification (IPC):
*H03K 19/0185* (2006.01)   *H03K 3/356* (2006.01)
*H03K 17/687* (2006.01)   *H03K 3/013* (2006.01)

(52) Cooperative Patent Classification (CPC):
**H03K 3/013; H03K 3/356; H03K 17/687;
H03K 19/0185**

(86) International application number:
**PCT/RU2023/000196**

(87) International publication number:
**WO 2025/009984 (09.01.2025 Gazette 2025/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Closed-up Joint-Stock Company Drive
Novosibirsk 630090 (RU)**

(72) Inventors:
• **ROMANOV, Yuriy Igorevich
 Novosibirsk, 630048 (RU)**
• **MALETSKIY, Stanislav Vladimirovich
 Novosibirsk, 630054 (RU)**

(74) Representative: **Spengler, Robert
Potthast & Spengler
Patentanwälte PartG mbB
Magirus-Deutz-Straße 12
89077 Ulm (DE)**

(54) **LEVEL SHIFTING DEVICE FOR CONTROLLING A POWER SWITCH (EMBODIMENTS)**

(57)   An apparatus 100 for level shifting used for controlling a power switch comprises a switch 140, a control pulse transmission channel 150, an interference transmission channel 130, and an interference suppression circuit 170. The apparatus is proposed in two embodiments, one also comprising a current generator 120, the other comprising a controllable current generator 1120. High interference immunity with insignificant power dissipation are achieved.

Fig.2a

## Description

## Field of the invention

The proposed inventions relate to power electronics and can be used in secondary power supply sources, inverters, HVAC systems, and other industrial and consumer devices. The proposed designs are intended for using in power switches in transferring a low-level pulse signal to a high-voltage level for controlling MOSFETs, Silicon carbide (SiC) FETs, Gallium Nitride (GaN) FETs, insulated gate bipolar transistors (IGBT), etc. that a power switch can be composed of.

## State of the art

In many cases nowadays, power electronics uses power switches - semiconductor devices for pulse converting electric power by closing and opening a power electric circuit.

Controlling a power switch is performed by low-level pulses, whereas high voltage transistors are used for switching a power circuit.

Widely used are power switches with two high voltage transistors, one of which (a high-level transistor) can be connected to a high voltage supply. Transferring a transistor controlling low voltage pulse signal to a high level is performed by level shift circuits (LSC) that can comprise a RS-trigger.

It has been known that, when working, power switches create high-intensity pulse interferences caused either by high level transistor switching or by breakdown of those transistors (in which case there can be a multiple pulse interference) or by some other reasons. Inputs of the RS triggers can be prone to the influence of those interferences resulting in false response of the RS trigger and catastrophic failure both the power switch and the equipment, where it is used, as a whole.

Degree of immunity of a LSC to switching and other interferences is measured by the interference rise rate dV/dt [V/ns] admittable for a specific device. For most LSC, using RS triggers, this value is standardized by a value of dV/dt = 50 V/ns. However, used increasingly frequently in modern power electronics are high speed SiCFET and GaNFET, for which dV/dt of up to 200 V/ns should be ensured. Therefore, developing LSC comprising no RS-triggers and intended for power switches with the high interference rise rate dV/dt [V/ns] presents a challenge bringing about the opportunity to create fault-free devices for power electronics.

For easy reference to the further description, some terms used therein are explained below.

An upper-level transistor, an upper transistor - a high voltage transistor of the power switch directly, or through a capacitor, connected to a high voltage source by one of its electrodes.

A lower-level transistor, a lower transistor - a high voltage transistor of the power switch connected to a common wire of the LSC by one of its electrodes.

Floating high voltage of the upper level - power supply of the device, the level thereof relative the common wire of the LSC depending on the presence or absence of a control pulse.

Floating bias voltage of the upper level - voltage at the point of connection of the upper and lower transistors, the level thereof relative the common wire of the LSC depending on the presence or absence of a control pulse.

A switch is closed - the resistance of the switch is inconsiderable.

A switch is open - the resistance of the switch is large.

A first electrode of a transistor - drain for FET, collector for bipolar transistors.

A second, controlling, electrode of a transistor - gate for FET, base for bipolar transistors.

A third electrode of a transistor - source for FET, emitter for bipolar transistors.

A controllable current generator - a current generator having a control input, the value of the current depending on the presence of a pulse at the control input.

Known in this field of art is a number of designs of LSC.

For example, used in a number of IC (see, for example International Rectifier - "Current Limiting Single Channel Driver" IR2125(S) & (PbF) Data Sheet No. PD60017 Rev.Q, September 12, 2004, or "ON Semiconductor FAN7083-GF085 High Side Gate Driver with Reset", September-2017, Rev. 2, as well as many others) is a design comprising a two-output generator of short pulses, a first and a second switches, a first and a second resistors, a two-input pulse filter, RS-trigger, an output stage, and a first terminal for receiving low-voltage supply.

In the design (device-analog), an input of the generator of short pulses is electrically connected to a second terminal of the device-analog; a second, control, terminal of the first switch is connected to a first output of the generator of short pulses; a second, control, terminal of the second switch is connected to a second output of the generator of short pulses;

first terminals of the first and second switches are connected to a third terminal of the device-analog, whereas third terminals of the first and second switches are connected to first terminals of the first and second resistors respectively; second terminals of the first and second resistors are connected to a fourth terminal of the device-analog; connection points of the switches and resistors are connected to the inputs of the pulse filter, while outputs thereof are connected to inputs of the RS-trigger; an output of the RS-trigger is connected to the output stage, while an output thereof is connected to a fifth terminal of the device-analog and power supply terminals of the output stage are connected to a fourth and a sixth terminals of the device-analog.

A shared feature of the first proposed technical design and the device-analog is the switch. At the same time, the second, control, terminal of the switch is connected with a control input of the device.

A shared feature of the second proposed technical design and the device-analog is also the switch. At the same time, the second, control, terminal of the switch is connected with a control input of the device.

A demerit of the known device is low immunity where high-intensity internal and external interferences exist (the value of dV/dt does not exceed 50 V/nsec). At the same time, having the RS-trigger in the structure of the device-analog sets the stage for catastrophic failures of the power switch and the whole device where it is used.

Also known is a technical design of a device-analog disclosed in the publication "A noise immunity improved level shift structure for a 600 V HVIC", Journal of Semiconductors, Vol.34, №6 June 2013, by Zhang Yunwu, et al.

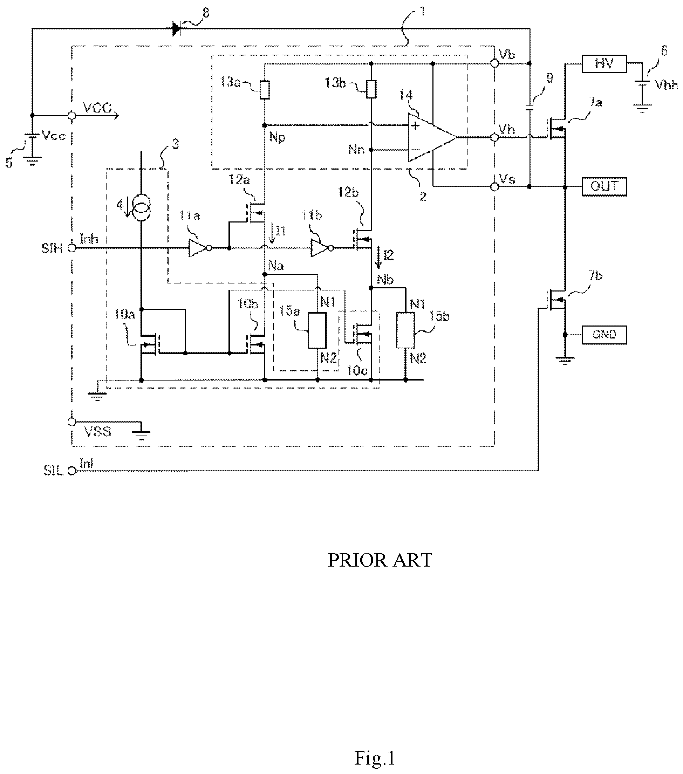

This device (see Fig. 1 of the publication) comprises:

a two-output generator of short pulses; a first and a second switches; a first and a second resistors, a two-input pulse filter; a RS-trigger; a first and a second diodes connected in parallel to, respectively, the first and second resistors; an interference suppression circuit; and a first terminal for receiving low-voltage power supply.

In the device, an input of the generator of short pulses is connected to a second terminal of the device-analog; a second, control, terminal of the first switch is connected to a first output of the generator of short pulses; a second, control, terminal of the second switch is connected to a second output of the generator of short pulses;

first terminals of the first and second switches are connected to a third terminal of the device-analog; third terminals of the first and second switches are respectively connected to first terminals of the first and second resistors, as well as to inputs of the interference suppression circuit, and outputs of the interference suppression circuit are connected with inputs of the pulse filter; second terminals of the first and second resistors are connected to a fourth terminal of the device-analog; outputs of the pulse filter are connected to inputs of the RS-trigger; an output of the RS-trigger is connected to a fifth terminal of the device-analog and is an output of the device.

Shared features of the first proposed technical design and the device-analog are the switch and interference suppression circuit, and the connection of the second, controlling, terminal of the switch to the control input of the device.

Shared features of the second proposed technical design and the device-analog are the switch and interference suppression circuit, and the connection of the second, controlling, terminal of the switch to the control input of the device.

The device-analog, however, does not provide sufficient immunity in the presence of high-intensity internal and external interferences, because, per the above reference, dV/dt does not exceed 65 V/ns.

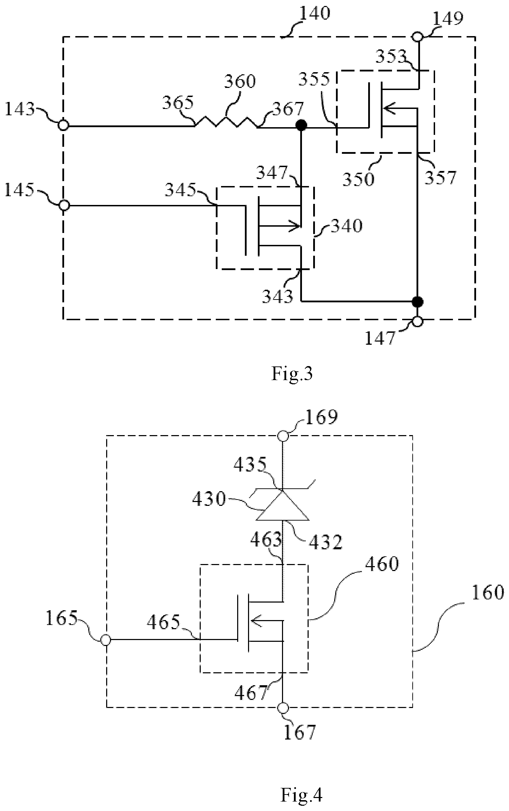

Also known is the circuit disclosed in US9,564,882 for a fast voltage level shifter published February 7, 2017. The circuit - analog comprises (see Fig. 3a of the publication), a current generator, an inverter, a first and a second switches, a first and a second resistors, a first and a second capacitors, a current setter (shown in Fig. 3b), and first and a second diodes.

An output of the current setter is connected to a control input of the current generator; an input of the current generator is connected to first terminals of the first and second switches; an output of the current generator is connected to the common wire of the circuit; a second, control, terminal of the first switch is directly connected to a control input of the circuit, whereas a second, control, terminal of the second switch is connected to a control input of the circuit via the inverter.

Third terminals of the first and second switches are connected to first terminals of the first and second resistors respectively.

Second terminals of the first and second terminals are connected to the circuit terminal receiving power supply. Anodes of the diodes are connected to each other and to the output of the circuit, whereas cathodes of the first and second diodes are connected to the first and second terminals of the first and second resistors respectively.

The first and second capacitors are connected in parallel to the first and second resistors respectively.

Shared features of the first proposed technical design and the circuit-analog are the current generator and switch. An input of the current generator is connected with a first terminal of the switch, an output of the current generator is connected to a common wire of the circuit, whereas a second, control, terminal of the switch is connected to a control input of the circuit.

A shared feature of the second proposed technical design and the circuit-analog is the switch. The second, control, terminal of the switch is connected to a control input of the circuit.

A disadvantage of the circuit-analog is increased energy consumption thereof due to having two resistors, flowing over which, alternatively yet constantly, is current caused by voltage equal to potential difference between fourth and third terminals of the circuit, which difference can reach hundreds of volts.

One more disadvantage of the circuit-analog is the presence of current surges triggered by recharging parasitic capacitances of the transistors used for the first and second switches. The surges may result in the crash of one of these switches or in generating a false output signal of the circuit.

A LSC disclosed in US9,264,022 published Feb. 16, 2016, is believed to be the closest analog (prototype). The known device, which is shown in Fig. 1 of the patent, corresponding to Fig. 1 of the present application, comprises a current setter, a current generator, a first and a second surge suppression circuits, a first and a second inverters, a first and a second switches, a first and a second resistors, an output stage, and a first terminal to receive low-voltage power supply. An output of the current setter is connected to a control input of the current generator, a first and a second inputs of the current generator are connected with first terminals of the first and second switches respectively, an output of the current generator is connected to a third terminal of the device-prototype.

Connected to the first terminals of the first and second switches are the first and second surge suppression circuits respectively.

A second, control, terminal of the first switch is connected via a first inverter to a second terminal of the device-prototype. A second, control, terminal of the second switch is connected to the second terminal of the device-prototype via the first and second inverters connected in series.

Third terminals of the first and second switches are connected to first terminals of the first and second resistors respectively, whereas second terminals of the first and second resistors are connected to a fourth terminal of the device-prototype. Points of connection of the switches and resistors are connected to inputs of the output stage, an output of the output stage is connected to a fifth terminal of the device-prototype, and power inputs of the output stage are connected to the fourth and a sixth terminals of the device-prototype.

Features shared by the first proposed technical design and the device-prototype are the current generator and switch.

With that, the input of the current generator is connected to the first terminal of the switch, the output of the current generator is connected to the third terminal of the device, and the second, control, terminal of the switch is connected to the second terminal of the device. Features shared by the second proposed technical design and the device-prototype is the switch. With that, the second, control, terminal of the switch is connected to the second terminal of the device.

A disadvantage of the device is increased energy consumption thereof due to current, alternatively yet constantly flowing through the first and second resistors, the current being caused by voltage close to potential difference between fourth and third terminals of the circuit, which difference can reach hundreds of volts.

## Summary of the invention

The object of the invention is overcoming demerits of the known devices and providing a LSC having increased interference immunity and insignificant power dissipation (comparable with power consumption of LSC using RS-triggers).

The technical result achievable in the proposed circuit and believed to be unachievable in known circuits amounts in both suppressing high-intensity pulse interferences having high rise rate and moderate power consumption.

It is believed that the prior art designs failed to achieve the above technical result because the object thereof was either stable functioning in the presence of high-intensity pulse interferences having high rise rate (at the expense of increased power consumption) or lowering power consumption (at the expense of lowering fail-safety), whereas achieving both objects at the same time was not an issue.

The above-mentioned technical result is achieved in the first embodiment of the proposed LSC (further also 'apparatus') for controlling a power switch by additionally providing an interference transmission channel, a control pulse transmission channel and an interference suppression circuit in the first apparatus comprising a current setter, a current generator, a surge suppression circuit, a switch, and an output stage.

An output of the current setter is connected with a control input of the current generator; an input of the current generator is connected to a first terminal of the switch; an output of the current generator is connected to a third terminal of the first apparatus; a second, control, terminal of the switch is connected with a second terminal of the first apparatus; and a first terminal of the switch is connected to the surge suppression circuit. A first and the second and the third terminal of the first apparatus serve for receiving low-voltage power supply, a control pulse, and for connecting to a common wire of the first apparatus, respectively, whereas a fourth, a fifth, and a sixth terminal of the first apparatus serve for, respectively, connecting to a supply source of the floating voltage of the upper level, a control electrode of the upper transistor of the power switch, and to a source of the floating bias voltage of the upper level.

Also, a third terminal of the switch is connected to an input of the control pulse transmission channel, whereas a power supply input of the switch, a power supply input of the interference transmission channel, and a power supply input of the current setter are all connected to the first terminal of the first apparatus. The control pulse transmission channel, interference transmission channel, and output stage are connected to the fourth and sixth terminals of the first apparatus in parallel. Outputs of the control pulse transmission channel and interference transmission channel are connected to inputs of the interference suppression circuit, and an output of the interference suppression circuit is connected with an input of the output stage an output thereof being connected to the fifth terminal of the first apparatus.

Also contributing to achieving the above-mentioned technical result in the first embodiment of the apparatus is that the control pulse, when there is no pulse interference, coming to the second terminal of the first apparatus closes the switch to secure flowing of current through the current generator and the control pulse transmission channel. The value of this current $I_0$ is set by the current setter and can be selected small enough to result in insignificant dissipation power during the control pulse, even when using high voltage power supply. Generated at the output of the control pulse transmission channel connected to the first input of the interference suppression circuit is a positive pulse relative to a potential at the sixth terminal of the first apparatus. At this time, potential of the sixth terminal of the first apparatus is kept at the output of the interference transmission channel connected to the second input of the interference suppression circuit.

In the interference suppression circuit, subtraction of output signals of those channels takes place resulting in forming a positive pulse applied to the output stage. Due to that pulse, the output stage submits potential of the fourth terminal of the first apparatus, sufficient for controlling the upper transistor of the power switch, to the fifth terminal of the first apparatus serving for connecting to the control electrode of the upper transistor of the power switch.

In the absence of the control pulse at the second terminal of the first apparatus, no positive pulse at the output of the control pulse transmission channel appears, and, accordingly, no pulse to control the upper transistor of the power switch appears at the fifth terminal of the first apparatus.

When high-intensity pulse interference appears at the sixth terminal of the first apparatus, it proceeds via the interference transmission channel to the second input of the interference suppression circuit. Via the control pulse transmission channel, this high-intensity pulse interference proceeds to the first input of the interference suppression circuit. The above input signals subtract from each other in the interference suppression circuit, which results in suppressing the high-intensity pulse interference regardless of the presence of the control pulse.

Consequently, due to including the interference transmission channel, control pulse transmission channel, and interference suppression circuit into the first embodiment of the apparatus, both suppressing high-intensity pulse interference having high rise rate and moderate (about 2-3 watt) power consumption are achieved, which is believed non-obvious and meeting the patentability requirement.

The above-mentioned technical result is achieved in the second embodiment of the proposed LSC for controlling a power switch (further 'second apparatus') by additionally providing a controllable current generator, an interference transmission channel, a control pulse transmission channel and an interference suppression circuit in a second apparatus comprising a current setter, a surge suppression circuit, a switch, and an output stage.

An output of the current setter is connected with a control input of the controllable current generator, an input of the controllable current generator is connected to a first terminal of the switch, an output of the controllable current generator is connected to a third terminal of the second apparatus, a second, control, terminal of the switch and an pulse input of the controllable current generator are connected to a second terminal of the second apparatus, and the surge suppression circuit is connected to the first terminal of the switch.

Additionally, a third terminal of the switch is connected to an input of the control pulse transmission channel, and power supply inputs of the switch, of the interference transmission channel, and of the current setter are connected to a first terminal of the second apparatus.

The control pulse transmission channel, interference transmission channel, and output stage are connected in parallel to a fourth and a sixth terminals of the second apparatus. Outputs of the control pulse transmission channel and of the interference transmission channel are connected to inputs of the interference suppression circuit, an output thereof being connected to an input of the output stage.

An output of the output stage is connected to a fifth terminal of the second apparatus, whereas low voltage power supply and a control pulse are applied respectively to the first and second terminals of the second apparatus, and the third terminal of the second apparatus is connected to a common wire of the second apparatus.

Also contributing to achieving the above-mentioned technical result in the second embodiment of the apparatus is that in the absence of pulse interference, the control pulse coming to the second terminal of the second apparatus closes the switch to secure flowing of current through the controllable current generator and the control pulse transmission channel. The value of this current $I_0$ is set by the current setter and can be selected small enough to provide insignificant dissipation power during the control pulse, even when using high voltage power supply.

The control pulse also comes to the controllable current generator to momentarily increase current $I_0$ for rapid charging capacitance of the transistor forming a part of the switch, to thus drive-up faster response of the second apparatus in comparison with the first one.

Generated at the output of the control pulse transmission channel connected to the first input of the interference suppression circuit is a positive pulse relative to a potential at the sixth terminal of the second apparatus. At this time, the potential of the sixth terminal of the second apparatus is kept at the output of the interference transmission channel connected to the second input of the interference suppression circuit.

In the interference suppression circuit, subtraction of output signals of those channels takes place resulting in forming a positive pulse applied to the output stage. Due to that pulse, the output stage submits potential of the fourth terminal of the second apparatus, sufficient for controlling the upper transistor of the power switch, to the fifth terminal of the second apparatus serving for connecting to the control electrode of the upper transistor of the power switch.

In the absence of the control pulse at the second terminal of the second apparatus, no positive pulse at the output of the control pulse transmission channel appears, and, accordingly, no pulse to control the upper transistor of the power switch appears at the fifth terminal of the second apparatus.

When a high-intensity pulse interference appears at the sixth terminal of the second apparatus, it proceeds via the interference transmission channel to the second input of the interference suppression circuit. Via the control pulse transmission channel, this high-intensity pulse interference proceeds to the first input of the interference suppression circuit. The above input signals subtract from each other in the interference suppression circuit, which results in suppressing the high-intensity pulse interference regardless of the presence of the control pulse. Consequently, due to including the interference transmission channel, control pulse transmission channel, interference suppression circuit, and the controllable current generator into the second embodiment of the apparatus, suppressing high-intensity pulse interference having high rise rate, moderate (about 2-3 watt) power consumption, and faster operation speed are also achieved.

This is believed to be non-obvious and meeting the patentability requirement in the second apparatus.

The performed analysis of the known designs in prior art showed that none of them comprises either the whole aggregation of limitations of the proposed apparatuses or distinctive features thereof which is indicative of meeting the novelty and inventive step criteria.

**Brief description of the drawings**

The claimed invention is explained further using accompanying drawings which present some implementations of the proposed LSC for controlling a power switch. The drawings are presented for better understanding the claimed invention, are included in the disclosure constituting a part thereof, and together with the specification serve for explaining mode of operation of the invention.

Fig. 1 shows the prototype (prior art).

Fig. 2a illustrates a block diagram of one of possible embodiments of the apparatuses, 100a.

Fig. 2b presents a block diagram of another possible embodiment of the apparatus, 100b.

Fig. 3 shows one of possible embodiments of the switch 140.

Fig. 4 shows one of possible embodiments of the surge suppression circuit 160.

Fig. 5a is one of possible embodiments of the interference suppression circuit, 170a.

Fig. 5b is another possible embodiments of the interference suppression circuit, 170b.

Fig. 6 illustrates one of possible embodiments of the output stage 180.

Fig. 7a shows one of possible embodiments of the current generator 120 according to the first embodiment of the apparatus.

Fig. 7b illustrates another possible embodiment of the controllable current generator 1120 according to the second embodiment of the apparatus.

Fig. 8 presents one of possible embodiments of the control pulse transmission channel 150.

Fig. 9 shows one of possible embodiments of the interference transmission channel 130, which is, short of insignificant difference, is similar to that presented in Fig. 8.

Fig. 10a presents the block diagram of one of possible embodiments of the apparatuses, 100a, in more detail as compared with Fig. 2a, disclosing elements presented in Figs. 3, 4, 5a, 6, 7a, 8, and 9.

Fig. 10b presents the block diagram of another possible embodiments of the apparatuses, 100b, in more detail as compared with Fig. 2b, disclosing elements presented in Figs. 3, 4, 5a, 6, 7b, 8, and 9.

**Detailed description of the invention, static.**

Presented below are specifics of the implementation of the claimed invention with reference to the drawings.

When applied to transistors, rather than to contacts and switches, the term "open", and derivatives therefrom, means "being in a conductive condition", whereas the term "close", and derivatives therefrom, means "being in a non-conductive condition."

Where in the specification or claims an element is said to be "connected" to another element, an immediate connection or electrical connection via a third element is meant.

Also, the term 'comprises' and its derivatives ('comprising', 'contained', 'including', and other similar terms) is understood as inclusion of those elements, rather than exclusion of any other elements, unless specifically noted otherwise.

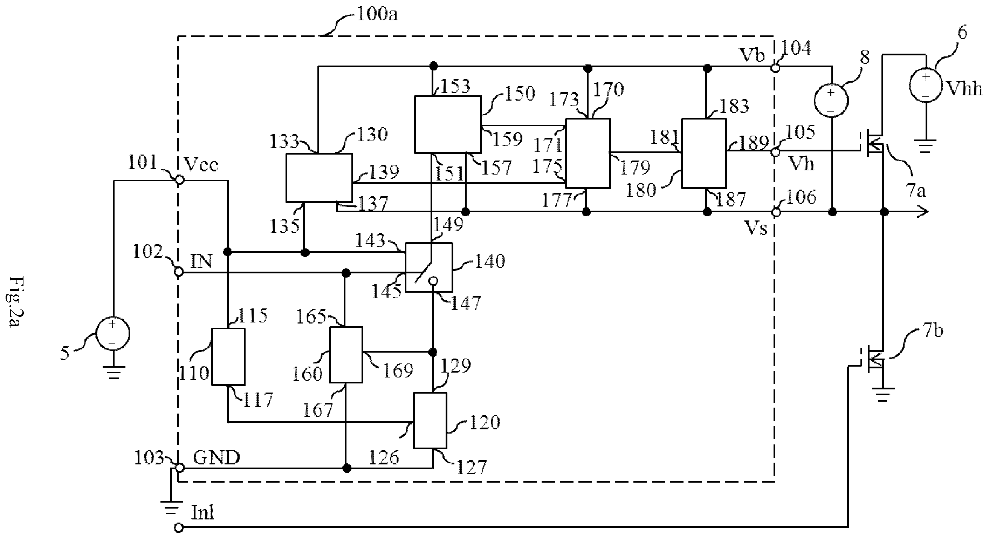

The claimed LSC for controlling a power switch, or apparatus, according to the first embodiment thereof is presented in Fig. 2a, where LSC as a whole is designated 100a. The LSC comprises a current setter 110, a current generator 120, an interference transmission channel 130, a switch 140, a control pulse transmission channel 150, a surge suppression circuit 160, an interference suppression circuit 170, and an output stage 180.

Also shown in Fig. 2a are elements of a power switch which are not parts of the LSC 100a - a low-voltage power supply source 5, a high-voltage power supply source 6, a power switch upper transistor 7a, a power switch lower transistor 7b, and a floating low-voltage power supply source 8, which can specifically comprise a diode and a boost capacitor - both not shown.

An input 101 Vcc of the LSC 100a is connected to a low-voltage power supply input 115 of the current setter 110, to the low-voltage power supply input 135 of the interference transmission channel 130, and to the low-voltage power supply input 143 of the switch 140. Output 117 of the current setter 110 is connected to a control input 126 of the current generator 120. A control input 102 IN of the LSC 100a is connected to a second, control, terminal 145 of the switch 140 and to a second, control, terminal 165 of the surge suppression circuit 160. A first terminal 127 of the current generator 120 and a first terminal of the surge suppression circuit 160 are connected to each other and to a terminal 103 GND of the LSC 100a serving for connecting a common wire of the LSC 100a. A second terminal 129 of the current generator 120 and a second terminal 169 of the surge suppression circuit 160 are connected to each other and to a first terminal 147 of the switch 140, a third terminal 149 of the switch 140 is connected to an input 151 of the control pulse transmission channel 150.

An output 159 of the control pulse transmission channel 150 is connected to a first input 171 of the interference suppression circuit 170, whereas connected to a second input 175 of the interference suppression circuit 170 is an output 139 of the interference transmission channel 130. An output 179 of the interference suppression circuit 170 is connected to an input 181 of the output stage 180, and an output 189 of the output stage 180 is connected to a fifth terminal 105 of the LSC 100a serving for connecting to a control electrode of the power switch upper transistor 7a.

A terminal 104 of the LSC 100a serving for connecting to a floating upper level high-voltage power supply $V_b$ is connected to power supply inputs 133, 153, 173, and 183 of the interference transmission channel 130, the control pulse transmission channel 150, the interference suppression circuit 170, and the output stage 180, respectively.

A terminal 106 of the LSC 100a serving for connecting floating upper-level bias voltage $V_s$ is connected to terminals 137, 157, 177, and 187 of the interference transmission channel 130, the control pulse transmission channel 150, the interference suppression circuit 170, and the output stage 180, respectively.

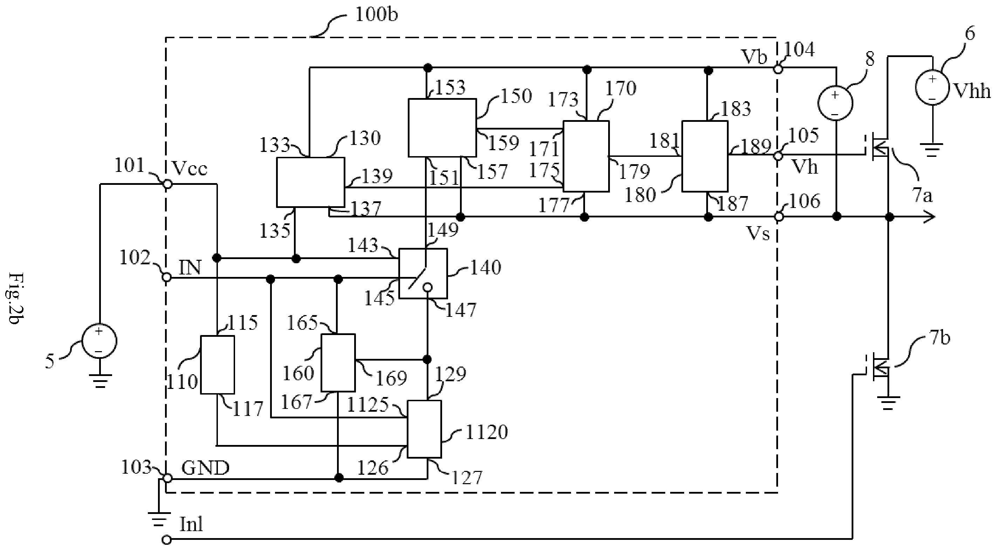

The proposed LSC according to the second embodiment thereof is presented in Fig. 2b, where LSC as a whole is designated 100b. Elements of the LSC shown in Fig. 2b and interconnections thereof are identical to those presented in Fig. 2a, with the exception that, instead of the current generator 120, a controllable current generator 1120 is used, a pulse input 1125 of the controllable current generator 1120 being connected to the control terminal 102 of the LSC 100b.

Fig. 3 illustrates one of the possible embodiments of switch 140 in the apparatus. It can be a part of any apparatuses implementing the proposed LSC. Shown in Fig. 3 are the switch 140, a first FET 340 of a p-type, a second FET 350 of n-type, a resistor 360.

The first terminal 365 of the resistor 360 is connected to the low-voltage power supply input 143 of the switch 140,

> a gate 345 of the first FET 340 is connected to the second, control, terminal 145 of the switch 140, a gate 355 of the second FET 350 is connected to a second terminal 367 of the resistor 360 and to a source 347 of the first FET 340, a drain 343 of the first FET 340 and a source 357 of the second FET 350 are connected to the first terminal 147 of the switch 140, and a drain 353 of the second FET 350 is connected to the third terminal 149 of the switch 140.

Presented in Fig. 4 is one of possible implementations of the surge suppressing circuit 160 in the proposed LSC. The circuit can be a part of any apparatuses implementing the proposed LSC. Designated in the circuit presented in Fig. 4 are: the whole circuit 160. A transistor 460 and a Zener diode 430. A gate 465 of transistor 460 is connected to the second, control, input 165 of the circuit 160. An anode 432 of the Zener diode 430 is connected to a drain 463 of the transistor 460, a cathode 435 of the Zener diode 430 is connected to the second terminal 169 of the surge suppression circuit 160, whereas a source 467 of the transistor 460 is connected to the first terminal 167 of the surge suppression circuit 160.

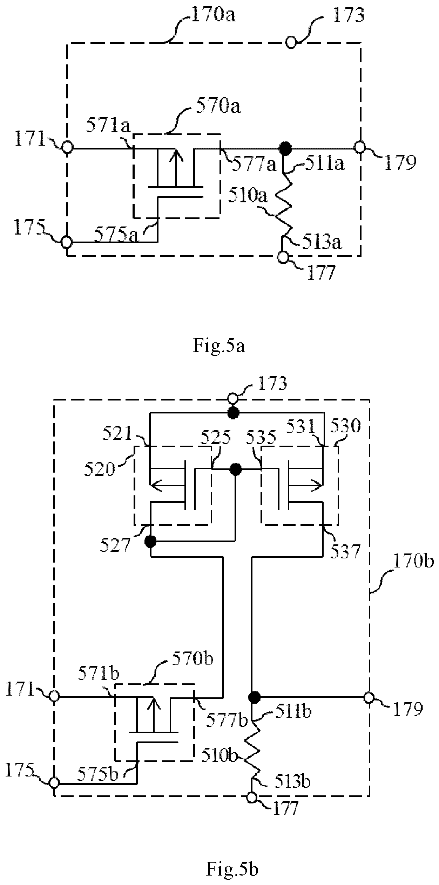

Fig. 5a illustrates one of the possible embodiments of the interference suppression circuit 170a in the apparatus. It can be a part of any apparatuses implementing the proposed LSC. Shown in Fig. 5a are a FET 570a of p-type and a resistor 510a. The first input 171 of the interference suppression circuit 170a is connected with a source 571a of the FET 570a, the second input 175 of the interference suppression circuit 170a is connected to a gate 575a of the FET 570a, the terminal 179 of the interference suppression circuit 170a is connected to a drain 577a of the FET 570a and to a first terminal 511a of the resistor 510a, and a second terminal 513a of the resistor 510a is connected with the terminal 177 of the interference suppression circuit 170a.

Presented in Fig. 5b is another of the possible embodiments of the interference suppression circuit 170b in the apparatus. It can be a part of any apparatuses implementing the proposed LSC. Shown in Fig. 5b are a first, a second, and a third FET 570b, 520, 530 of p-type, and a resistor 510b. The first input 171 of the interference suppression circuit 170b is connected to a source 571b of the first p-type FET 570b, and the second input 175 of the interference suppression circuit 170b is connected to a gate 575b of the first p-type FET 570b.

A drain 577b of the first p-type FET 570b is connected to a drain 527 of the second p-type FET 520 and to a point of connection of gates 525 and 535 of the second, 520, and third, 530, p-type FET, respectively. A source 521 of the second p-type FET 520 and a source 531 of the third p-type FET 530 are connected to each other and to the power supply input 173 of the interference suppression circuit 170. As a result, the pair of the p-type FET 520 and 530, together with connections thereof, forms a current mirror.

The output 179 of the interference suppression circuit 170b is connected with a drain 537 of the third p-type FET 530 and with a first terminal 511b of the resistor 510b, whereas a second terminal 513b of the resistor 510b is connected to the terminal 177 of the interference suppression circuit 170b.

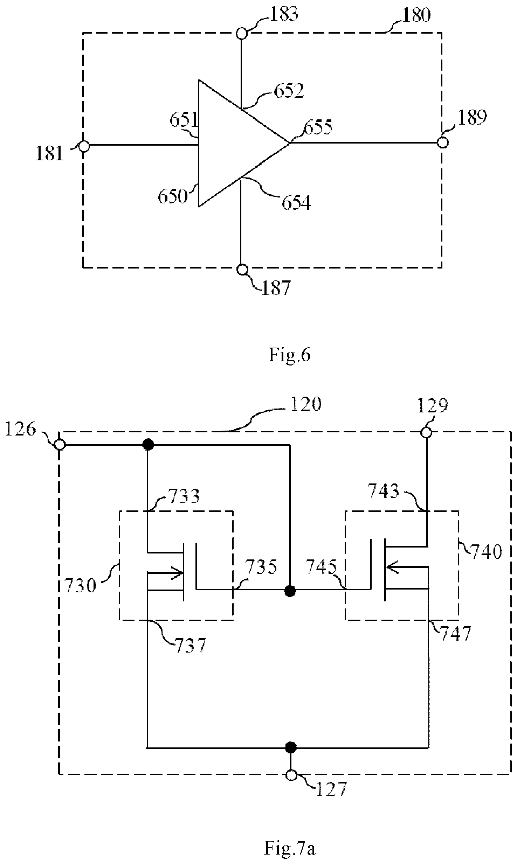

Presented in Fig. 6 is one of the possible implementations of the output stage 180. It can be a part of any apparatuses implementing the proposed LSC.

Shown in Fig. 6 are: the output stage 180, and a Schmidt trigger 650.

The first input 181 of the output stage 180 is connected to an input 651 of the Schmidt trigger 650. An output 655 of the Schmidt trigger 650 is connected to terminal 189 of the output stage 180. A power supply input 652 of the Schmidt trigger 650 is connected with the power supply input 183 of the output stage 180, and a terminal 654 of the Schmidt trigger 650 for connecting to the common wire of the LSC is connected to the terminal 187 of the output stage 180.

Fig. 7a presents one of the possible implementations of the current generator in accordance with the first embodiment of the proposed LSC. It can be a part of any apparatuses implementing the first embodiment of the LSC. Shown in Fig. 7a are: the current generator 120 as a whole, a first transistor 730 and a second transistor 740.

A drain 733 of the first transistor 730, as well as a connection point of a gate 735 of the first transistor 730 and a gate 745 of the second transistor 740 are connected to the control input 126 of the current generator 120. A drain 743 of the second transistor 740 is connected to the second terminal 129 of the current generator 120. A source 737 of the first transistor 730 and a source 747 of the second transistor 740 are connected to each other and to the first terminal 127 of the current generator 120.

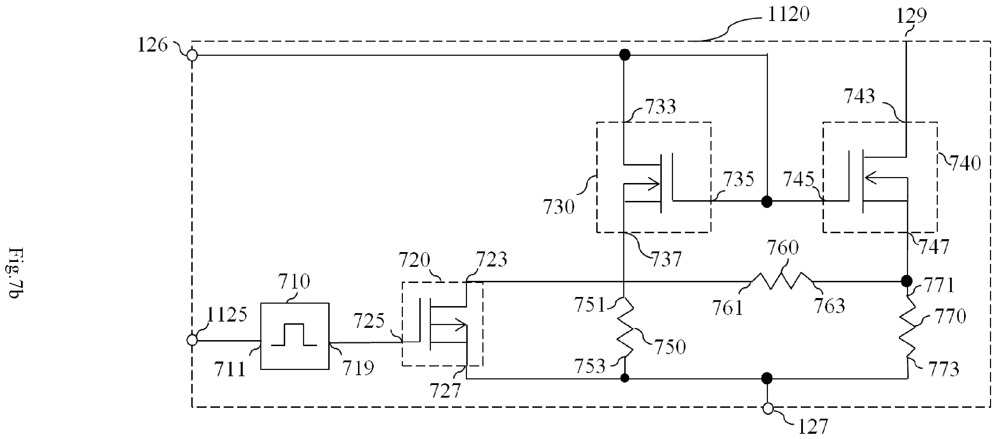

Fig. 7b presents one of the possible implementations of the current generator in accordance with the second embodiment of the proposed LSC. It can be a part of any apparatuses implementing the second embodiment of the LSC. Shown in Fig. 7b are: a controllable current generator, as a whole, 1120, the first transistor 730, the second transistor 740, a third transistor 720, a driven multivibrator 710, and a first, 750, a second, 770, and a third, 760, resistors with terminals 751 and 753, 771 and 773, 761 and 763, respectively.

The drain 733 of the first transistor 730, as well as the connection point of gate 735 of the first transistor 730 and the gate 745 of the second transistor 740 are connected to the control input 126 of the controllable current generator 1120.

The drain 743 of the second transistor 740 is connected to the second terminal 129 of the controllable current generator 1120.

The source 737 of the first transistor 730 is connected via the first resistor 750 to the first terminal 127 of the controllable current generator 1120, and the source 747 of the second transistor 740 is connected to the same terminal 127 via the second resistor 770. The terminal 763 of the third resistor 760 is connected to a common point of the second resistor 770 and the source 747 of the second transistor 740.

The terminal 761 of the third resistor 760 is connected to a drain 723 of the third transistor 720. In its turn, a gate 725 of the third transistor 720 is connected to an output 719 of the driven multivibrator 710, a source 727 of the third transistor 720 is connected to the first terminal 127 of the controllable current generator 1120, and an input 711 of the driven multivibrator 710 is connected to a pulse input 1125 of the controllable current generator 1120.

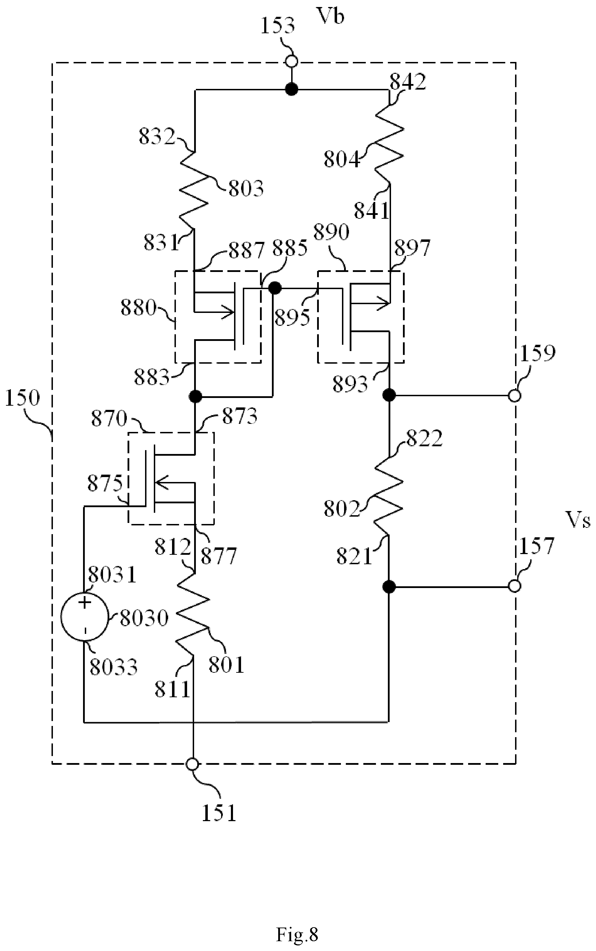

Fig. 8 illustrates one of possible implementations of the control pulse transmission channel 150 in the proposed LSC. It can be a part of any apparatuses implementing the LSC. Presented in Fig. 8 are: the control pulse transmission channel as a whole - 150, a first FET 870, a second FET 880, a third FET 890, a low voltage power supply source 8030, a positive pole thereof 8031, a negative pole thereof 8033, a first, 801, a second, 802, a third, 803, and a fourth, 804, resistors respectively.

A gate 875 of the first FET 870 is connected to the positive pole 8031 of the low-voltage power supply source 8030, a source 877 of the first FET 870 is connected to a second terminal 812 of the first resistor 801, a first terminal 811 thereof being connected to the input 151 of the control pulse transmission channel 150.

A drain 873 of the first FET 870 is connected to a drain 883 of the second FET 880 and to a point of connection of gates 885 and 895 of the second, 880, and the third, 890, FET respectively. A source 887 of the second FET 880 is connected to a first terminal 831 of the third resistor 803, a second terminal 832 thereof being connected to the power supply input 153 of the control pulse transmission channel 150.

A drain 893 of the third FET 890 is connected to a second terminal 822 of the second resistor 802 and to the output 159 of the control pulse transmission channel 150, whereas a source 897 of the third FET 890 is connected to a first terminal 841 of the fourth resistor 804, a second terminal 842 thereof being connected to the power supply input 153 of the control pulse transmission channel 150. The first terminal 821 of the second resistor 802 is connected to the negative pole 8033 of the low-voltage power supply source 8030 and to the terminal 157 of the control pulse transmission channel 150.

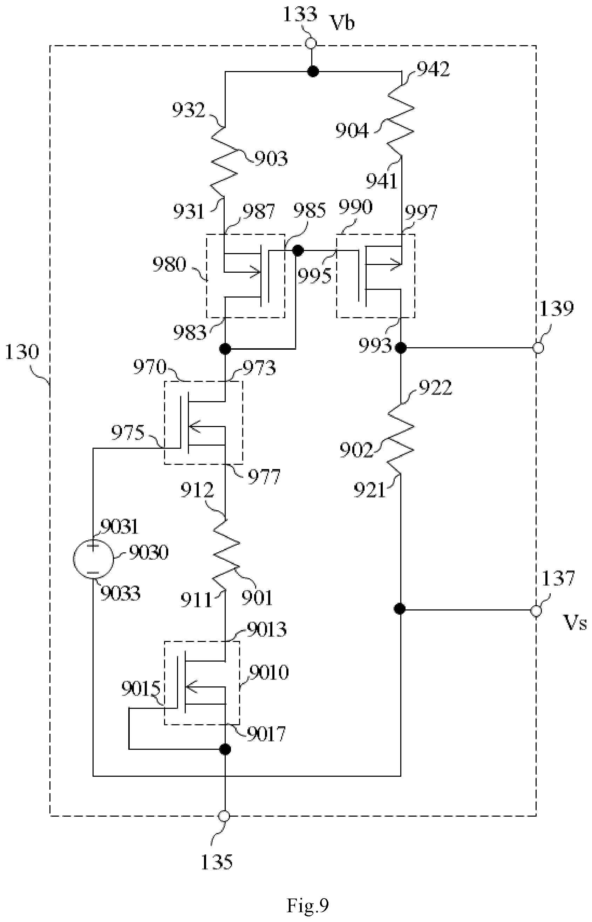

Fig. 9 illustrates one of possible implementation of the interference transmission channel 130 in the claimed LSC. It can be a part of any apparatuses implementing the LSC. Designated in Fig. 9 are: the interference transmission channel as a whole - 130, a first FET 970, a second FET 980, a third FET 990, a fourth FET 9010. A low voltage power supply source is designated 9030, a positive pole thereof - 9031, a negative pole thereof - 9033, and resistors - a first 901, a second 902, a third 903, and a fourth 904.

A gate 9015 and a source 9017 of the fourth FET 9010 are connected to each other and to the low-voltage power supply input 135, whereas a drain 9013 of the fourth FET 9010 is connected to a first terminal 911 of a first resistor 901.

A second terminal 932 of the third resistor 903 and a second terminal 942 of the fourth resistor 904 are connected to each other and to the power supply input 133 of the interference transmission channel 130. A drain 993 of the third FET 990 is connected to the output 139 of the interference transmission channel 130. The first terminal 921 of the second resistor 902 is connected to the terminal 137 of the interference transmission channel 130.

Other connections between elements of the interference transmission channel 130 are similar to those in the control pulse transmission channel 150.

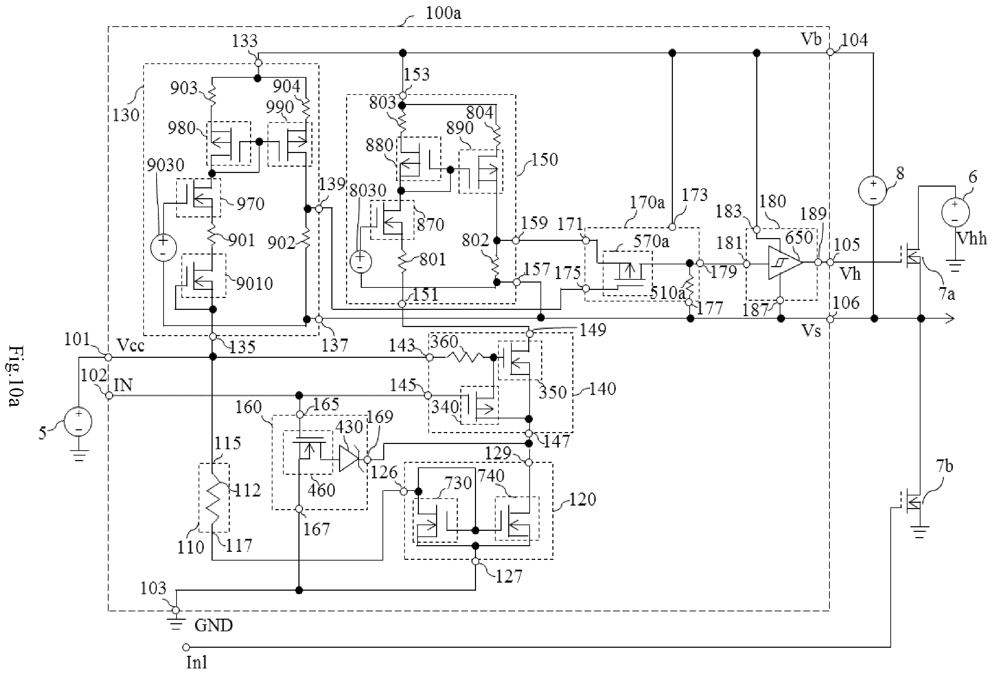

Fig. 10a illustrates elements included in the functional units shown in Fig. 2a and their connections for one of the possible implementations of the first embodiment of the proposed apparatus (LSC).

The claimed LSC is designated 100a. Included in the LSC are: the current setter 110, the current generator 120, the interference transmission channel 130, the switch 140, the control pulse transmission channel 150, the surge suppression circuit 160, the interference suppression circuit 170, and the output stage 180.

Also shown in Fig. 10a are the following elements of the power switch, which do not compose the LSC 100a: the low-voltage power supply source 5, the high-voltage power supply source 6, the upper, 7a, transistor of the power switch, the lower, 7b, transistor of the power switch, and the floating low-voltage power supply source 8 which can specifically comprise a diode and a boost capacitor - both not shown.

Input 101 Vcc of the apparatus 100a is connected to the low-voltage power supply input 115 of the current setter 110, to the low-voltage power supply input 135 of the interference transmission channel 130, and to the low-voltage power supply input 143 of the switch 140. The output 117 of the current setter 110, which includes the resistor 112, is connected to the control input 126 of the current generator 120.

The current generator 120 includes a current mirror and comprises two transistors, 730 and 740, the gates of the transistors 730 and 740 being connected to each other, to the drain of the transistor 730, and to the control input 126 of the current generator 120. The sources of the transistors 730 and 740 are connected to each other and to the first terminal 127 of the current generator 120.

The drain of the transistor 740 is connected to the second terminal 129 of the current generator 120 which terminal 129, in turn, is connected to the second terminal 169 of the surge suppression circuit 160 and to the first terminal 147 of the switch 140. The surge suppression circuit 160 includes transistor 460 and Zener diode 430, the gate of the transistor 460 being connected to the second, control, terminal 165 of the surge suppression circuit 160, the terminal 165 being also connected to the control input 102 of the apparatus 100a and to the second, control, terminal 145 of the switch 140. The drain of the transistor 460 is connected to the anode of the Zener diode 430, and the cathode thereof is connected to the second terminal 169 of the surge suppression circuit 160. The source of the transistor 460 is connected to the first terminal 167 of the surge suppression circuit 160 which terminal 167 is connected to the terminal 103 of the apparatus 100a, serving for connecting to the common wire of the LSC, and to the first terminal 127 of the current generator 120.

The switch 140 comprises the p-type FET 340 and the n-type FET 350. The gate of the p-type FET 340 is connected to the second, control, terminal 145 of the switch 140, the source of this transistor is connected to the first terminal 147 of the switch 140 and to the source of the n-type FET 350, the drain of the n-type FET 350 being connected to the third terminal 149 of the switch 140. The drain of the p-type FET 340 is connected with the gate of the n-type FET 350 and - via the resistor 360 - with the low-voltage power supply input 143 of the switch 140. The control terminal 145 of the switch 140 is connected to the control input 102 IN of the apparatus 100a, and the third terminal 149 of the switch is connected to the input 151 of the control pulse transmission channel 150.

Control pulse transmission channel 150 comprises the first FET 870, two transistors together forming a current mirror - the second FET 880 and the third FET 890, the low voltage power supply source 8030, the first resistor 801, the second resistor 802, the third resistor 803, and the fourth resistor 804. Connected to the input 151 of the control pulse transmission channel 150 are the first resistor 801 and - in series therewith - the first FET 870, the second FET 880, and the third resistor 803 connected to the power supply input 153 of the control pulse transmission channel 150. Connected to the terminal 157 of the control pulse transmission channel 150 are the second resistor 802 and - in series therewith - the third FET 890 and the fourth resistor 803 also connected to the power supply input 153 of the control pulse transmission channel 150.

Also connected to the terminal 157 of the control pulse transmission channel 150 is the negative pole of the low voltage power supply source 8030, the positive pole thereof being connected to the gate of the first FET 870.

The gates of the second FET 880 and of the third FET 890 are connected to each other, to the drain of the first FET 870, and to the source of the second FET 880. The join of the drain of the third FET 890 and the second resistor 802 is connected to the output 159 of the control pulse transmission channel 150.

The interference transmission channel 130 comprises the first FET 970, two transistors together forming a current mirror - the second FET 980 and the third FET 990, the fourth FET 9010, the low voltage power supply source 9030, the first resistor 901, the second resistor 902, the third resistor 903, and the fourth resistor 904.

Connected to the low-voltage power supply input 135 of the interference transmission channel 130 are the fourth FET 9010 and - in series therewith - the first resistor 901, the first FET 970, the second FET 980, and the third resistor 903 connected to the power supply input 133 of the interference transmission channel 130. Connected to the terminal 137 of the interference transmission channel 130 are the second resistor 902 and - in series therewith - the third FET 990 and the fourth resistor 904 which is also connected to the power supply input 133 of the interference transmission channel 130. Also connected to terminal 137 of the interference transmission channel 130 is the negative pole of the low voltage power supply source 9030, the positive pole thereof being connected to the gate of the first FET 970. The gates of the second FET 980 and of the third FET 990 are connected to each other, to the drain of the first FET 970, and to the source of the second FET 980. The join of the drain of the third FET 990 and of the second resistor 902 is connected to the output 139 of the interference transmission channel 130, whereas the gate and the source of the fourth FET 9010 are connected to each other.

The interference suppression circuit 170 comprises p-channel FET 570a and resistor 510a. A source of the p-channel FET 570a is connected to the first input 171 of the interference suppression circuit 170, a gate of the p-channel FET 570a being connected to the second input 175 of the interference suppression circuit 170. A drain of the p-channel FET 570a is connected to the output 179 of the interference suppression circuit 170, the resistor 510a being connected between this output 179 and the terminal 177 of the interference suppression circuit 170.

The output stage 180 comprises Schmidt trigger 650, an input of Schmidt trigger 650 being connected to the input 181 of the output stage 180, an output of the Schmidt trigger 650 being connected to the output 189 of the output stage 180, power supply inputs of the Schmidt trigger 650 being respectively connected to the power supply input 183 and the terminal 187 of the output stage 180.

The output 159 of the control pulse transmission channel 150 is connected with the first input 171 of the interference suppression circuit 170, the second input 175 thereof being connected to the output 139 of the interference transmission channel 130. The output 179 of the interference suppression circuit 170 is connected to the input 181 of the output stage 180, the output 189 thereof being connected to the terminal 105 of the apparatus 100a serving for connecting the control electrode of the upper transistor 7a of the power switch.

The terminal 104 of the apparatus 100a, serving for connecting to floating upper-level power supply voltage Vb, is connected to the power supply inputs 133, 153, 173, and 183 of the interference transmission channel 130, the control pulse transmission channel 150, the interference suppression circuit 170, and the output stage 180, respectively.

In this implementation, the power supply input 173 of the interference suppression circuit 170 is not used.

The terminal 106 of the apparatus 100a, serving for connecting to floating upper-level bias voltage Vs, is connected to the power inputs 137, 157, 177, and 187 of the interference transmission channel 130, the control pulse transmission channel 150, the interference suppression circuit 170, and the output stage 180, respectively.

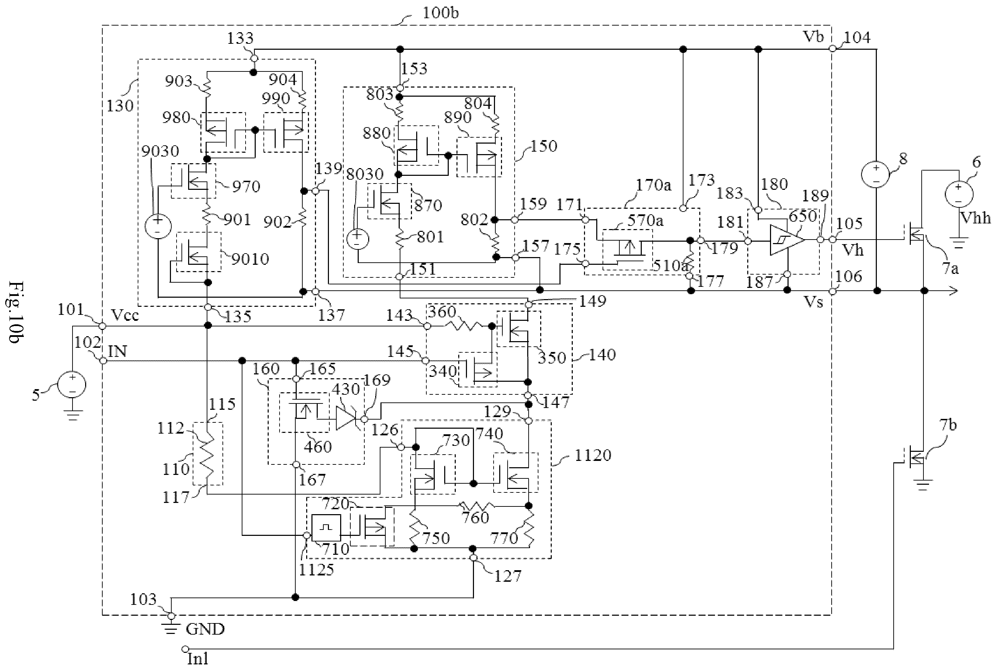

Fig. 10b presents elements, which the functional units shown in Fig. 2b are composed of, and connections thereof - for one of possible realizations of the second embodiment of the proposed apparatus (LSC).

The claimed LSC is designated 100b. Included in the LSC 100b are the current setter 110, the controllable current generator 1120, the interference transmission channel 130, the switch 140, the control pulse transmission channel 150, the surge suppression circuit 160, the interference suppression circuit 170a, and the output stage 180.

Also shown in Fig. 10b are the following elements of the power switch, which do not compose the LSC 100b: the low-voltage power source 5, the high-voltage power supply source 6, the upper, 7a, transistor of the power switch, the lower, 7b, transistor of the power switch, and the floating low-voltage power supply source 8 which can specifically comprise a diode and a boost capacitor - both not shown.

The input 101 Vcc of the apparatus 100a is connected to the low-voltage power supply input 115 of the current setter 110, to the low-voltage power supply input 135 of the interference transmission channel 130, and to the low-voltage power supply input 143 of the switch 140. The output 117 of the current setter 110, which includes the resistor 112, is connected to the control input 126 of the controllable current generator 1120.

The controllable current generator 1120 in Fig 10b includes the first transistor 730, the second transistor 740, the third transistor 720, the driven multivibrator 710, the first, 750, the second, 770, and the third, 760, resistors.

The gates of the first and second transistors 730 and 740 are connected to each other, to the drain of the first transistor 730, and to the control input 126 of the controllable current generator 1120.

The drain of the second transistor 740 is connected to the second terminal 129 of the controllable current generator 1120.

The source of the first transistor 730 is connected to the first terminal 127 of the controllable current generator 1120 via the first resistor 750, and the source of the second transistor 740 is connected to the same first terminal 127 of the controllable current generator 1120 via the second resistor 770.

One of the terminals of the third resistors 760 of the controllable current generator 1120 is connected to a common point of the source of the second transistor 740 and the second resistor 770, the other terminal of the third resistor 760 being connected to the drain of the third transistor 720. Also, the gate of the third transistor 720 is connected to the output of the driven multivibrator 710, the source of the third transistor 720 is connected to the first terminal 127 of the controllable current generator 1120, and the input of the driven multivibrator 710 is connected to the pulse input 1125 of the controllable current generator 1120, which is connected to the control input 102 IN of the LSC 100b.

The switch 140 comprises the p-type FET 340 and the n-type FET 350. The gate of the p-type FET 340 is connected to the second, control, terminal 145 of the switch 140, the source of this transistor is connected to the first terminal 147 of the switch 140 and to the source of the n-type FET 350, the drain of the n-type FET 350 being connected to the third terminal 149 of the switch 140. The drain of the p-type FET 340 is connected with the gate of the n-type FET 350 and - via the resistor 360 - to the low-voltage power supply input 143 of the switch 140. The control terminal 145 of the switch 140 is connected to the control input 102 IN of the apparatus 100a, and the third terminal 149 of the switch is connected to the input 151 of the control pulse transmission channel 150.

Control pulse transmission channel 150 comprises the first FET 870, two transistors together forming a current mirror - the second FET 880 and the third FET 890, the low voltage power supply source 8030, the first resistor 801, the second resistor 802, the third resistor 803, and the fourth resistor 804. Connected to the input 151 of the control pulse transmission channel 150 are the first resistor 801 and - in series therewith - the first FET 870, the second FET 880, and the third resistor 803 connected to the power supply input 153 of the control pulse transmission channel 150. Connected to the terminal 157 of the control pulse transmission channel 150 are the second resistor 802 and - in series therewith - the third FET 890 and the fourth resistor 803 also connected to the power supply input 153 of the control pulse transmission channel 150.

Also connected to terminal 157 of the control pulse transmission channel 150 is the negative pole of the low-voltage power supply source 8030, the positive pole thereof being connected to the gate of the first FET 870.

The gates of the second FET 880 and of the third FET 890 are connected to each other, to the drain of the first FET 870, and to the source of the second FET 880. The join of the drain of the third FET 890 and the second resistor 802 is connected to the output 159 of the control pulse transmission channel 150.

The interference transmission channel 130 comprises the first FET 970, two transistors together forming a current mirror - the second FET 980 and the third FET 990, the fourth FET 9010, the low-voltage power supply source 9030, the first resistor 901, the second resistor 902, the third resistor 903, and the fourth resistor 904.

Connected to the low-voltage power supply input 135 of the interference transmission channel 130 are the fourth FET 9010 and - in series therewith - the first resistor 901, the first FET 970, the second FET 980, and the third resistor 903 connected to the power supply input 133 of the interference transmission channel 130.

Connected to the terminal 137 of the interference transmission channel 130 are the second resistor 902 and - in series therewith - the third FET 990 and the fourth resistor 904 which is also connected to the power supply input 133 of the interference transmission channel 130. Also connected to terminal 137 of the interference transmission channel 130 is the negative pole of the low voltage power supply source 9030, the positive pole thereof being connected to the gate of the first FET 970. The gates of the second FET 980 and of the third FET 990 are connected to each other, to the drain of the first FET 970, and to the source of the second FET 980. The join of the drain of the third FET 990 and of the second resistor 902 is connected to the output 139 of the interference transmission channel 130, whereas the gate and the source of the fourth FET 9010 are connected to each other.

The interference suppression circuit 170 comprises p-channel FET 570a and resistor 510a. A source of the p-channel FET 570a is connected to the first input 171 of the interference suppression circuit 170, a gate of the p-channel FET 570a being connected to the second input 175 of the interference suppression circuit 170. A drain of the p-channel FET 570a is connected to the output 179 of the interference suppression circuit 170, the resistor 510a being connected between this output 179 and the terminal 177 of the interference suppression circuit 170.

The output stage 180 comprises Schmidt trigger 650, an input of Schmidt trigger 650 being connected to the input 181 of the output stage 180, an output of the Schmidt trigger 650 being connected to the output 189 of the output stage 180, power supply inputs of the Schmidt trigger 650 being respectively connected to the power supply input 183 and the terminal 187 of the output stage 180.

The output 159 of the control pulse transmission channel 150 is connected to the first input 171 of the interference suppression circuit 170, the second input 175 thereof being connected to the output 139 of the interference transmission channel 130. The output 179 of the interference suppression circuit 170 is connected with the input 181 of the output stage 180, the output 189 thereof being connected to the terminal 105 of the LSC 100b serving for connecting the control electrode of the upper transistor 7a of the power switch.

The terminal 104 of the apparatus 100b, serving for connecting to floating upper-level power supply voltage Vb, is connected to the power supply inputs 133, 153, 173, and 183 of the interference transmission channel 130, the control pulse transmission channel 150, the interference suppression circuit 170, and the output stage 180, respectively.

In this implementation, the power supply input 173 of the interference suppression circuit 170 is not used.

The terminal 106 of the apparatus 100b, serving for connecting to floating upper-level bias voltage Vs, is connected to the power inputs 137, 157, 177, and 187 of the interference transmission channel 130, the control pulse transmission channel 150, the interference suppression circuit 170, and the output stage 180, respectively.

**Operation of the invention.**

The LSC 100a in one of possible implementation according to the first embodiment of the proposed apparatus operates as follows (see Fig. 2a).

When a control pulse IN comes to the control input 102 and further to the second, control, terminal 145 of the switch 140, the switch 140 closes, and current $I_0$ starts flowing along the circuit: the terminal 104 of the LSC 100a, which connects the floating upper-level power supply voltage, - the power supply input 153 of the control pulse transmission channel 150 - the control pulse transmission channel 150 - the switch 140 - the current generator 120 - the first terminal 127 of the current generator 120 - the terminal 103 of the LSC 100a for connecting the common wire of the LSC 100a.

This circuit closes due to connecting the common wire of the LSC 100a to the source of transistor 7b and the negative pole of the high-voltage power supply source 6, which are not a part of the LSC 100a.

The value of this current $I_0$ is defined by the current generator 120 controlled via the control input 126 thereof from the output 117 of the current setter 110. In turn, the low-voltage power supply input 115 of the current setter 110 is connected to the input 101 of LSC 100a where low voltage supply $V_{cc}$ comes from the low voltage power supply source 5, which is not a part of the LSC 100a.

The value of the low voltage supply $V_{cc}$ can be within the range of 4.5 - 5.5V relative to the potential of the common wire of the LSC 100a.

The value of power supply voltage $V_b$ of the upper transistor of power switch (the floating power supply source 8) can be within the 12 - 18 V range relative to potential $V_s$ at the terminal 106 of the LSC 100a, whereas the value of high-voltage power supply $V_{hh}$ (the high-voltage power supply source 6) can be within the 500 - 600V, or other ranges depending on working environment of the power switch.

The above-mentioned $I_0$, flowing along the circuit "the terminal 104 - the terminal 103 of the LSC 100a" is supported stable during the control pulse IN due to the current generator 120, the value thereof being established by the current setter 110 at the extremely low level (such as a few milliamperes) to lower power consumption.

Most commonly, a current setter is a series connection of a constant voltage source and a constant resistor, disclosed, for example, in the above-mentioned US 9,564,882 B2, though more complicated schematics is also possible.

Generated at the output 159 of the control pulse transmission channel 150 during the control pulse IN and in the interference free condition is a pulse of positive polarity relative to voltage $V_s$ at the terminal 106 of the LSC 100a which is applied to the first input 171 of the interference suppression circuit 170. Output voltage from the output 139 of the interference transmission channel 130, which is equal to the potential $V_s$ at the terminal 106 of the LSC 100a under considered conditions, is applied to the second input 175 of the interference suppression circuit 170 due to connection of the terminal 106 and terminal 137 of the interference transmission channel 130. A positive polarity pulse formed at the output 179 of the interference suppression circuit 170 comes to the input 181 of the output stage 180. It causes the output stage 180 to transmit from the output 189 thereof to the terminal 105 of the LSC 100a the positive polarity pulse as a pulse $V_h$ for controlling the upper transistor of the power switch.

After the control pulse IN ended, the switch 140 opens, the current in the circuit "the terminal 104 - the terminal 103 of the LSC 100a" stops flowing, the pulses at the output 159 of the control pulse transmission channel 150 and at the output 179 of the interference suppression circuit 170, as well as the pulse $V_h$ at the output 105 of the LSC 100a end.

At the appearance at terminal 106 of the LSC 100a of large pulse interference, brought forth usually by switching transistors of the power switch and characterized by high rise rate dV/dt, the pulse thereof comes simultaneously to the terminals 137 and 157 of the interference transmission channel 130 and the control pulse transmission channel 150, respectively.

Due to the high identity of channels 130 and 150 (and taking into account the switch 140), the interference pulses come to the outputs 139 and 159 thereof and to the inputs 171 and 175 of the interference suppression circuit 170 simultaneously and equal in amplitude. Therefore, mutual compensation of those pulses takes place in the interference suppression circuit 170, and the large pulse interference is practically non-existent at the output 179 of the interference suppression circuit 170, as well as at the output 189 of the output stage 180 and at the output 105 of the LSC 100a, the mutual compensation of the large pulse interference taking place whether there is or there is no control pulse IN.

In this way, simultaneously ensured are the suppression of large pulse interference having high rise rate and moderate power consumption in the normal mode of operation that provides achieving of the declared technical result.

The LSC 100b in one of the possible implementation according to the second embodiment of the proposed apparatus operates as follows (see Fig. 2b).

When a control pulse IN comes to the control input 102 of the LSC 100b and further to the second, control, terminal 145 of the switch 140, the switch 140 closes, and current $I_0$ starts flowing along the circuit: the terminal 104 of the LSC 100b, which connects the floating upper-level power supply voltage, - the power supply input 153 of the control pulse transmission channel 150 - the control pulse transmission channel 150 - the switch 140 - the controllable current generator 1120 - the first terminal 127 of the controllable current generator 1120 - the terminal 103 of the LSC 100b for connecting the common wire of the LSC 100b.

This circuit closes due to connecting the-common wire of the LSC 100b to the source of transistor 7b and the negative pole of the high-voltage power supply source 6, which are not a part of the LSC 100b.

The value of this current $I_0$ is defined by the controllable current generator 1120 controlled via the control input 126 thereof from the output 117 of the current setter 110. In turn, the low-voltage power supply input 115 of the current setter 110 is connected to the input 101 of LSC 100b where low voltage supply $V_{cc}$ comes from the low-voltage power supply source 5, which is not a part of the LSC 100b.

The value of the low-voltage power supply $V_{cc}$ can be within the range of 4.5 - 5.5V relative to the potential of the common wire of the LSC.
The value of power supply voltage $V_b$ of the upper transistor of power switch (the floating power supply source 8) can be within the 12 - 18V range relative to potential $V_s$ at the terminal 106 of the LSC 100b, whereas the value of high-voltage power supply $V_{hh}$ (the high voltage power supply source 6) can be within the 500 - 600V, or other ranges depending on working environment of the power switch.

The above-mentioned $I_0$, flowing along the circuit "the terminal 104 - the terminal 103 of the LSC 100b" is supported stable during the control pulse IN due to the controllable current generator 1120, the value thereof being established by the current setter 110 at the extremely low level (such as a few milliamperes) to lower power consumption.

Most commonly, a current setter is a series connection of a constant voltage source and a constant resistor, disclosed, for example, in the above-mentioned US 9,564,882 B2, though more complicated schematics is also possible.

However, the control pulse IN also comes from the control input 102 of the LSC 100b to the pulse input 1125 of the controllable current generator 1120. During short duration, this results in sharp rise of current along the circuit "the terminal 104 - the terminal 103 of the LSC 100b" topping the value $I_1 = 5...15 I_0$ in the beginning of the control pulse IN. The time of rise of the current is less than one percent of the duration of the control pulse IN. The current $I_1$ charges capacitance of the switch 140 which contributes to high-speed performance of the LSC 100b in accordance with the second embodiment of the proposed apparatus. Due to the short duration of the $I_1$, the power consumed by the apparatus changes little if at all.

Generated at the output 159 of the control pulse transmission channel 150 during the control pulse IN and in the interference free condition is a pulse of positive polarity relative to voltage $V_s$ at the terminal 106 of the LSC 100b which is applied to the first input 171 of the interference suppression circuit 170. Output voltage from the output 139 of the interference transmission channel 130, which is equal to the potential $V_s$ at the terminal 106 of the LSC 100b under considered conditions, is applied to the second input 175 of the interference suppression circuit 170 due to connection of the terminal 106 and terminal 137 of the interference transmission channel 130. A positive polarity pulse formed at the output 179 of the interference suppression circuit 170 comes to the input 181 of the output stage 180. It causes the output stage 180 to transmit from the output 189 thereof to the terminal 105 of the LSC 100b the positive polarity pulse as a pulse $V_h$ for controlling the upper transistor of the power switch.

After the control pulse IN ended, the switch 140 opens, the current in the circuit "the terminal 104 - the terminal 103 of the LSC 100a" stops flowing, the pulses at the output 159 of the control pulse transmission channel 150 and at the output 179 of the interference suppression circuit 170, as well as the pulse $V_h$ at the output 105 of the LSC 100b end.

At the appearance at the terminal 106 of the LSC 100b of large pulse interference, brought forth usually by switching transistors of the power switch and characterized by high rise rate dV/dt, the pulse thereof comes simultaneously to the terminals 137 and 157 of the interference transmission channel 130 and the control pulse transmission channel 150, respectively.

Due to the high identity of channels 130 and 150 (and taking into account the switch 140), the interference pulses come to the outputs 139 and 159 thereof and to the inputs 171 and 175 of the interference suppression circuit 170 simultaneously and equal in amplitude. Therefore, mutual compensation of those pulses takes place in the interference suppression circuit 170, and the large pulse interference is practically non-existent at the output 179 of the interference suppression circuit 170, as well as at the output 189 of the output stage 180 and at the output 105 of the LSC 100b, the mutual compensation of the large pulse interference taking place whether there is or there is no control pulse IN.

In this way, simultaneously ensured are the suppression of large pulse interference having high rise rate and moderate power consumption in the normal mode of operation that provides achieving of the declared technical result. Additionally ensured is improved response time of the LSC due to short time rise of the current flowing through the controllable current generator 1120, the switch 140, and the control pulse transmission channel 150 in the beginning of the control pulse IN.

Components of the claimed LSC can be implemented in various ways.

Particularly, Fig. 3 presents one of possible implementations of the switch 140 which may be used in both embodiments of the proposed design and operates as follows (see also Figs. 2a, 2b).

When the control pulse IN comes to the second, control, terminal 145, the transistor 340 closes, and resistance between the first electrode 343 and the third electrode 347 thereof becomes very high. At the same time, the transistor 350 is open due to potential $V_{cc}$ at the low-voltage power supply input 143 which comes through the resistor 360 to the second, control, electrode 355 of the transistor 340. Consequently, current flows through the switch 140 along the following circuit: the third terminal 149 of the switch 140 - the first electrode 353 of the transistor 350 - the third electrode 357 of the transistor 350 - the first terminal 147 of the switch 140, meaning that the switch 140 is closed.

After the control pulse IN ends, transistor 340 opens, the resistance between the first electrode 343 and the third electrode 347 thereof becomes low, and the potential difference between the second, control, electrode 355 and the third electrode 357 of the transistor 350 becomes close to zero. This causes the closing of the transistor 350, the above circuit of current flowing between terminals 149 and 147 opens, and the switch 140 is open.

Having transistor 340 in the switch 140 accelerates the closing of the switch because low resistance of the opening transistor 340 short-circuits high capacity of transistor 350, and, thus, the overall speed of the claimed LSC increases.

Presented in Fig. 4 is a possible implementation of the surge suppression circuit 160 in the claimed LSC which can be used in both versions of the proposed design. **In** many prior art apparatuses (such as the analog (see US 9,564,882 B2)), at the leading edge of the control pulse IN, voltage surge appears at the drain 353 of the transistor 350 due to the cross capacitance of the transistor 350 of the switch 140 and passes to the third electrode 357 of the transistor 350. The surge may cause an input barrier breakdown in the transistor 350 and the total failure of the claimed LSC.

In the prototype (US 9,264,022), a surge suppression circuit connected in parallel to a current generator is used. The surge suppression circuit 160 in the claimed LSC is also connected in parallel to the current generator 120 (see Fig. 2a) or in parallel to the controllable current generator 1120 (see Fig. 2b) but, unlike the prototype, it comprises the Zener diode 430 and the transistor 460 connected in series.

The surge suppression circuit 160 implemented according to Fig. 4 operates as follows (see also Figs. 2a, 2b).

The control pulse IN comes from the control input 102 of the claimed LSC to the second, control, input 165 connected to the gate 465 of the transistor 460 and opens the transistor. Since the cathode 435 of the Zener diode 430, via the second terminal 169 of the surge suppression circuit 160 and the first terminal 147 of the switch 140, is connected to the third electrode 357 of the transistor 350 of the switch 140 (see Fig. 3), the potential of the third electrode 357 of the transistor 350 becomes equal at this moment to the voltage at the cathode 435 of the Zener diode 430 composed of the voltage across the opened transistor 460 plus the stabilization voltage of the Zener diode 430 and amounts to very few volts.

Voltage at the second (control) electrode 355 of the transistor 350 is equal to the potential $V_{cc}$ of the low-voltage power supply source 5 at the low-voltage power supply input 143 of the switch 140, the potential difference between the second (control) electrode 355 of the transistor 350 and the cathode 435 of the Zener diode 430 is quite small, therefore the input barrier breakdown in the transistor 350 under the circumstances is impossible.

When the control pulse IN ends, the transistor 460 opens, thus cutting off the Zener diode 430 from the first terminal 167 of the surge suppression circuit 160 and preventing the Zener diode 430 from failure because of the potential $V_{cc}$ of the low-voltage power supply source 5 coming to the cathode 435 of the Zener diode 430 from the low-voltage power supply input 143 of the switch 140 via short-circuited transistor 340.

Shown in Fig. 8 is a possible implementation of the control pulse transmission channel 150 which can be used in both embodiments of the proposed design and operates as follows.

When the control pulse IN appears at the control input 102 of the claimed LSC (see Figs. 2a, 2b) and passes to the second (control) terminal 145 of the switch 140, the latter closes and creates a circuit for current to flow from the power supply input 153 of the control pulse transmission channel 150 to the first terminal 127 of the current generator 120 (see Fig. 2a) or to the first terminal 127 of the controllable current generator 1120 (see Fig. 2b).

The current flows in the control pulse transmission channel 150 along the following circuit (see Fig. 8): the power supply input 153 - the third resistor 803 - the second transistor 880 - the first transistor 870 - the first resistor 801 - the input 151 of the control pulse transmission channel 150.

When the control pulse IN is present, the first transistor 870 is in conducting state due to voltage of the DC voltage source 8030 and serves as a buffer stage contributing to sufficient fast response of the circuit being described.

The transistor pair of the second transistor 880 and the third transistor 890 forms a current mirror and therefore, when the current flows through the second transistor 880, a current flows through the third transistor 890 as well, the value of this current being defined by the nominal ratio of the third resistor 803 and the fourth resistor 804. This current creates a voltage drop across resistor 802 which passes to the terminal 159 as an output pulse of the control pulse transmission channel 150, the amplitude of the pulse exceeds the potential $V_s$ of the terminal 157 by a prescribed value.

If during the presence of the control pulse IN a high-intensity pulse interference appears at the terminal 157 of the control pulse transmission channel 150, an inrush current appears along the circuit: the power supply input 153 - the third resistor 803 - the second transistor 880 - the first transistor 870 - the first resistor 801 - the input 151 of the control pulse transmission channel 150. At the same time, due to the effect of the current mirror, a pulse interference current flows as well through the fourth resistor 804 and the third transistor 890 creating an additional voltage drop across the second resistor 802. This voltage drop is added to the voltage of the output pulse of the control pulse transmission channel 150 and passes to the output 159 as the output signal comprising the sum of the control pulse and the high-intensity pulse interference.

Where there is no control pulse IN at the control input 102 of the claimed LSC, and the switch 140 is open (see Figs. 2a, 2b), there is no current along the circuit between the power supply input 153 and the input 151 of the control pulse transmission channel 150 (see Fig. 8). Similarly, the current does not flow along the circuit between the power supply input 153 and the terminal 157 of the control pulse transmission channel 150. Therefore, there is no output pulse of the control pulse transmission channel 150.

If, however, during the absence of the control pulse a high-intensity pulse interference appears at the terminal 157 of the control pulse transmission channel 150, an in-rush current again appears along the circuit: the power supply input 153 - the third resistor 803 - the second transistor 880 - the first transistor 870 - the first resistor 801 - the input 151 of the control pulse transmission channel 150. Also, due to the effect of the current mirror, a pulse interference current flows as well through the fourth resistor 804 and the third transistor 890 creating an additional voltage drop across the second resistor 802. This voltage drop passes to the output 159 as the output signal comprising the pulse interference.

So, always present at the output 159 of the control pulse transmission channel 150 during the control pulse IN is the output control pulse, to which an interference pulse is added if a high-intensity pulse interference appears. When there is no control pulse IN, there is no output control pulse at the output 159 of the control pulse transmission channel 150, and when the high-intensity pulse interference is present, the interference pulse appears at the output 159.

Presented in Fig. 9 is a possible implementation of the interference transmission channel 130 which can be used in both embodiments of the proposed design and operates similarly to the control pulse transmission channel 150, but with the following peculiarities:

1) The control pulse does not come to the interference transmission channel 130, but it has the fourth transistor 9010 (permanently closed due to the connection of the second (control) electrode 9015 and the third electrode 9017) similar to the transistor 350 of the switch 140 (see Fig. 3). Therefore the parameters of the circuit: the power supply input 133 - the third resistor 903 - the second transistor 980 - the first transistor 970 - the first resistor 901 - the fourth transistor 9010 are similar to the respective circuit in the control pulse transmission channel 150 shown in Fig. 8 (and taking into account the switch 140, Fig. 3) except that no current flows along this circuit during both the presence and absence of the control pulse. No current flows respectively along the following circuit: the power supply input 133 - the fourth resistor 904 - the third transistor 990 - the second resistor 902 - the terminal 137 of the interference transmission channel 130. Therefore, the output pulse of the interference transmission channel 130 appears at the output 139 neither during the presence of the control pulse IN nor when it is absent.
2) When a high-intensity pulse interference appears at terminal 137 of the interference transmission channel 130, channel 130 operates similarly to the control pulse transmission channel 150, and the interference pulse is always present at the output 139 of the interference transmission channel 130 when the high-intensity pulse interference comes.

So, the control pulse is always absent at the output 139 of the interference transmission channel 130, whereas the interference pulse appears if and only if the high-intensity pulse interference appears at terminal 137.

Since channel 130 of control pulse transmission and 150 of interference pulse transmission are carried out similarly (taking into account the switch 140), high degree of similarity is achieved in the interference pulses coming to the inputs 171 and 175 of the interference suppression circuit 170.

Fig. 5a illustrates a possible version of the interference suppression circuit 170a in the claimed LSC. If there is no interference, the circuit operates as follows.

When the control pulse IN comes to the control input 102 of the claimed LSC, a pulse with the amplitude that exceeds the potential $V_s$ of terminal 157 by a set value appears at the output 159 of the control pulse transmission channel 150 (see Figs. 2a, 2b). This pulse comes to the first input 171 of the interference suppression circuit 170a and passes to the third electrode 571a of the transistor 570a. At the same time, coming from the output 139 of the interference transmission channel 130 to the second input 175 of the circuit 170a is voltage equal to the potential $V_s$ at the terminal 106 of the claimed LSC, which is passed to the second, control, electrode 575a of the transistor 570a.

Due to potential difference between inputs 171 and 175, a difference pulse of the positive polarity is formed across the resistor 510a of the interference suppression circuit 170a passing to the output 179 of the circuit 170a.

If there is no control pulse IN, voltages at the source 571a and at the second, control, electrode 575a of the transistor 570a are equal, and formed at the resistor 510a of the interference suppression circuit 170a which is connected to the first electrode 577a of the transistor 570a is a zero-difference signal which passes to the output 179 of the circuit 170a.

When both the control pulse and the high-intensity pulse interference are present at the output 159 of the control pulse transmission channel 150 and pass to the input 171 of the circuit 170a, a high-intensity pulse interference, similar by the amplitude and shape to that at the input 171, is also present at the output 139 of the interference transmission circuit 130 (and, respectively, at the second input 175 of the interference suppression circuit 170a). In this case, subtraction of pulse interferences at the inputs 171 and 175 occurs, and a difference signal as a pulse of the positive polarity and of the set amplitude is formed at the resistor 510a connected with the first electrode 577a of the transistor 570a of the interference suppression circuit 170a, the positive pulse passing to the output 179 of the circuit 170a.

If the high-intensity pulse interference appears in the absence of the control pulse, the voltages at the third electrode 571a and at the second, control, electrode 575a of the transistor 570a are equal, and formed at the resistor 510a connected with the first electrode 577a of the transistor 570a is a zero-difference signal passing to the output 179 of the interference suppression circuit 170a.

Thus, if the control pulse is present at input 171 of the interference suppression circuit 170a, the difference signal as a positive pulse is formed at the output 179 thereof whether the high-intensity pulse interference is present or not.

If the control pulse is absent at input 171 of the interference suppression circuit 170a, the zero-difference signal is formed at the output 179 thereof whether the high-intensity pulse interference is present or not.

Which means that the high-intensity pulse interference does not at all come to the input 181 of the output stage 180 (see Figs. 2a, 2b) and hence does not come to the output $V_h$ of the claimed LSC which provides high fail-safety where high-intensity pulse interferences with high rise rate happen.

The interference suppression circuit 170b presented in Fig. 5b can be used in both embodiments of the proposed LSC and operates as follows.

When the control pulse IN comes to the control input 102 of the claimed LSC in the absence of the high-intensity pulse interference, a pulse with the amplitude that exceeds the potential $V_s$ of terminal 157 by a set value appears at the output 159 of the control pulse transmission channel 150 (see Figs. 2a, 2b).

This pulse comes to the first input 171 of the interference suppression circuit 170b and passes to the third electrode 571b of the transistor 570b. At the same time, coming from the output 139 of the interference transmission channel 130 to the second input 175 of the circuit 170b is voltage equal to the potential $V_s$ at the terminal 106 of the claimed LSC, which is passed to the second, control, electrode 575b of the transistor 570b. Due to the potential difference between the inputs 171 and 175, the transistor 570b is open, and current flows therethrough along the circuit: the power supply input 173 - the transistor 520 - the transistor 570b - the first input 171 of the interference suppression circuit 170. Since the pair of the transistors 520 and 530 with the connections thereof form a current mirror, the same current flows along another circuit: the power supply input 173 - the transistor 530 - the resistor 510b - the terminal 177 of the interference suppression circuit 170b.

Formed at the resistor 510b at this time is a difference signal as a pulse of the positive polarity which proceeds to the output 179.

When the control pulse IN is absent, voltage at the third electrode 571b and at the second, control, electrode 575b of the transistor 570b are equal to each other, and formed at the resistor 510b is a zero-difference signal which proceeds to the output 179.

When present at the output 159 of the control pulse transmission channel 150 are both the control pulse and the high-intensity pulse interference which pass to the input 171 of the interference suppression circuit 170b, also present at the output 139 of the interference transmission channel 130 (and, respectively, at the second input 175 of the interference suppression circuit 170b) is a high-intensity pulse interference which is similar by shape and amplitude to that at the input 171. In this case, subtraction of pulse interferences at the inputs 171 and 175 occurs, and a difference signal as a pulse of the positive polarity and a set amplitude is formed at the resistor 510b passing to the output 179 of the circuit 170b.

If the high-intensity pulse interference appears in the absence of the control pulse, the voltages at the third electrode 571b and at the second, control, electrode 575b of the transistor 570b are equal, and formed at the resistor 510b is a zero-difference signal passing to the output 179 of the interference suppression circuit 170b.

Thus, if the control pulse is present at input 171 of the interference suppression circuit 170b, the difference signal as a positive pulse is formed at the output 179 thereof whether the high-intensity pulse interference is present or not.

If the control pulse is absent at the input 171 of the interference suppression circuit 170b, the zero-difference signal is formed at the output 179 thereof whether the high-intensity pulse interference is present or not.

Which means that the high-intensity pulse interference does not come at all to the input 181 of the output stage 180 (see Fig. 2, 2b) and hence does not come to the output $V_h$ of the claimed LSC which provides high fail-safety where high-intensity pulse interferences with high rise rate happen.

Fig. 6 presents a possible implementation of the output stage 180 which can be used in both embodiments of the proposed LSC and operates as follows.
The control pulse cleared of interference by the interference suppression circuit 170 (see Figs. 2a, 2b) arrives at the input 181 of the output stage 180 and further to the input 651 of the Schmidt trigger 650 converting the analog input signal into the digital output one. From the output 655 of the Schmidt trigger 650, the control pulse proceeds to the output 189 of the output stage 180 (and further to the output 105 of the claimed LSC) having sufficiently sharp edges to switch on the upper-level transistor 7a of the power switch (shown in Figs. 2a, 2b and is not a part of the LSC).

Shown in Fig. 7a is a possible implementation of the current generator 120 made as a current mirror according to the first embodiment of the LSC.

In such current generators, the first, 730, and the second, 740, transistors are identical.

The current generator 120 operates as follows.

The input current $I_0$ created by the current setter 110 (see Fig. 2a) flows in the current generator 120 along the following circuit: the control input 126 - the first transistor 730 - the first terminal 127 of the current generator 120. The potential difference between the second (control) electrode 735 and the third electrode 737 of the first transistor 730 equals to the potential difference between the second (control) electrode 745 and the third electrode 747 of the second transistor 740, and therefore current $I_0$, which is equal to the input one, flows through the second transistor 740. And this current is permanent and does not depend on the parameters of the load connected to the second terminal of the current generator 120.

A possible implementation of the controllable current generator 1120 according to the second embodiment of the LSC is shown in Fig. 7b and operates as follows.

The input current $I_0$ generated by the current setter 110 (see also Fig.2b) flows in the controllable current generator 1120 in the following circuit: the controlling input 126 of the controllable current generator 1120 - the first transistor 730 - the first resistor 750 - the first terminal 127 of the controllable current generator 1120. If the resistance of the first, 750, and the second, 770, resistors are equal, a current $I_0$ equal to the input current flows through the transistor 740 as well. This current is continuous, not dependent on parameters of the load connected to the second terminal 129 of the controllable current generator 1120.

When the control pulse IN arrives from the pulse input of the controllable current generator 1120 to the input 711 of the driven multivibrator 710, at the multivibrator output 719 a short pulse is generated, the length thereof being a fraction of a percent of the duration of the pulse IN. This pulse comes to the second, control, electrode 725 of the third transistor 720 and opens it. Due to small resistance of the third transistor 720 in the open state thereof, the terminal 761 of the third resistor 760 - via the first electrode 723 and the third electrode 727 of the third transistor 720 - turns out practically immediately connected to the first terminal 127 of the controllable current generator 1120, and the third resistor 760 turns out connected in parallel to the second resistor 770 of the controllable current generator 1120. Usually, the resistance of the third resistor 760 is selected 5...15 times less than that of the second resistor 770, therefore the current through the controllable current generator 1120 increases at about the same ratio reaching the level of $I_1 = 5...15 I_0$. Upon completion of the short pulse at the output 719 of the driven multivibrator 710, the third transistor 720 closes, the resistance between the first, 723, and the third, 727, electrodes thereof becomes very high, and the third resistor 760 becomes disconnected from the first terminal 127 of the controllable current generator 1120. Therefore, during the rest of the duration of the control pulse IN, the current $I_0$ flows through the controllable current generator 1120.

The LSC 100a in one of possible implementations thereof shown in Fig. 10a, which presents the elements disclosed in Figs. 3, 4, 5a, 6, 7a, 8, 9 according to the first embodiment of the proposed apparatus, operates as follows.

When the control pulse IN comes to the control input 102 of the LSC 100a and further appears at the second, control, terminal 145 of the switch 140, the transistor 340 closes, and the resistance between the first and the third electrodes thereof becomes very high. The transistor 350 at the same time is open due to the potential $V_{cc}$ at the low-voltage power supply input 143 of the switch 140 passing via the resistor 360 to the second (control) electrode of the transistor 340. Hence, the current flows via the transistor 350 (and therefore via the switch 140) along the following circuit: the terminal 104 of the LSC 100a, serving for connecting of floating upper-level high-voltage power supply - the power supply input 153 of the control pulse transmission channel 150 - the third resistor 803, the second transistor 880, the first transistor 870, and the first resistor 801 of the control pulse transmission channel 150 - the transistor 350 of the switch 140 - the transistor 740 of the current generator 120 - the first terminal 127 of the current generator 120 - the terminal 103 of the LSC 100a serving for connecting to the common wire of the LSC. The circuit closes due to the connection of that common wire of the LSC with the source of the transistor 7b and the negative pole of the high-voltage power supply source 6.

After the control pulse IN ends, the transistor 340 of the switch 140 opens, the resistance between the first electrode 353 (drain) and the third electrode 357 (source) becomes low, and the potential difference between the second, control, electrode 355 (gate) and the third electrode 357 of the transistor 350 of the switch 140 becomes close to zero. Therefore, the transistor 350 closes, the switch 140 is now open, and the above-described current flowing circuit is also open.

Having the transistor 340 in the switch 140 accelerates the process of closing of the switch because the small resistance of the opening transistor 340 shunts high input capacity of the transistor 350, and the total speed of the LSC 100a increases.

The value of $I_0$, flowing during the control pulse IN is defined by the current generator 120:

$$I_0 = (V_{cc} - V_d) / R_{112},$$

where $V_{cc}$ - low-voltage power supply coming to the first terminal 101 of the LSC 100a from the low-voltage power supply source 5 not included in the LSC 100a, $V_d$ - voltage between the second (control) and the third electrodes of the transistor 730 of the current generator 120, and $R_{112}$ - resistance of the resistor 112 of the current setter 110.

The value of the low-voltage power supply $V_{cc}$ can be within 4.5...5.5 V relative to the potential of the common wire of the LSC, whereas the value of $I_0$ is set using the current setter 110 at the extremely low level (the very few milliamperes, for example) to lower power consumption.

The surge suppression circuit 160 is used for preventing the breakdown of the input barrier of the transistor 350 of the switch 140 which can result in failure both the transistor 350 and the whole LSC 100a. The breakdown can happen at the moment of the leading front of the control pulse IN when a voltage surge occurs at the first electrode of the transistor 350 and passes to the third electrode of the transistor 350 of the switch 140 via the cross capacitance of this transistor.

The surge suppression circuit 160 operates as follows.

The control pulse IN comes from the control input 102 of the LSC 100a to the second (control) input 165 connected to the second electrode of the transistor 460 and opens the transistor 460. As the anode of the Zener diode 430 via the second terminal 169 of the surge suppression circuit 160 and the first terminal 147 of the switch 140 is connected to the third electrode of the transistor 350 of the switch 140, the potential of the third electrode of the transistor 350 is equal at this moment to the voltage at the anode of the Zener diode 430. This voltage comprises the voltage at the open transistor 460 and the voltage stabilizing the Zener diode 430 and amounts to a few volts. The voltage at the second (control) electrode of the transistor 350 is equal to the potential $V_{cc}$ of the low-voltage power supply source 5 at the low-voltage power supply input 143 of the switch 140, the potential difference between the second, control, electrode of the transistor 350 and the anode of the Zener diode 430 is rather small, and, therefore, the breakdown of the input barrier of the transistor 350 in light of this is impossible.

As the control pulse IN ends, transistor 460 closes, cutting the Zener diode 460 off the first terminal 167 of the surge suppression circuit 160 and thus prevents the Zener diode 460 from failure because of the potential $V_{cc}$ of the low-voltage power supply source 5 coming to the anode of the Zener diode 430 from the low-voltage power supply input 143 of the switch 140 via the short-circuited transistor 340.

The control pulse transmission channel 150 (see Fig. 8) operates as follows.

Generated at the output 159 of the control pulse transmission channel 150 during the control pulse IN and in the absence of the interference (situation 1) is a pulse of the positive polarity relative to the voltage $V_s$ at the terminal 106 of the LSC 100a passing to the first input 171 of the interference suppression circuit 170.

The pulse is generated in the following way: when the control pulse IN appears at the control input 102 of the LSC 100a and passes to the second, control, terminal 145 of the switch 140, the latter closes and thus creates a circuit for the current flowing from the power supply input 153 of the control pulse transmission channel 150 to the first terminal 127 of the current generator 120.

This current flows in the control pulse transmission channel 150 along the following circuit: the power supply input 153 - the third resistor 803 - the second transistor 880 - the first transistor 870 - the first resistor 801 - the input 151.

The first transistor 870 is open by the voltage of the DC voltage source 8030 when the control pulse IN is present and serves a buffer stage ensuring sufficient operation speed of the circuit under consideration.

The pair of transistors - the second, 880, and the third, 890, forms a current mirror, therefore as the current flows through the second transistor 880, a current flows through the third transistor 890 as well. The value of this current is defined by the nominal ratio of the third resistor 803 and the fourth resistor 804. This current creates a voltage drop across resistor 802 which passes to the terminal 159 as an output pulse of the control pulse transmission channel 150, the amplitude of the pulse exceeds the potential $V_s$ of the terminal 157 by a prescribed value.

If, during the presence of the control pulse IN, a high-intensity pulse interference appears at the terminal 157 of the control pulse transmission channel 150 (situation 2), an in-rush current appears along the circuit: the power supply input 153 - the third resistor 803 - the second transistor 880 - the first transistor 870 - the first resistor 801 - the input 151 of the control pulse transmission channel 150. At the same time, due to the effect of the current mirror, a pulse interference current flows through the fourth resistor 804 and the third transistor 890 as well and creates an additional voltage drop across the second resistor 802. This voltage drop is added to the voltage of the output pulse of the control pulse transmission channel 150 and passes to the output 159 as the output signal comprising the sum of the control pulse and the high-intensity pulse interference.

Where there is no control pulse IN at the control input 102 of the LSC 100a (situation 3), the switch 140 cuts the circuit of the current flowing between the power supply input 153 and the input 151 of the control pulse transmission channel 150. Similarly, the current does not flow through the fourth resistor 804 - the third transistor 890 - the second resistor 802, and there is no output pulse of the control pulse transmission channel 150.

If, during the absence of the control pulse a high-intensity pulse interference appears at the terminal 157 of the control pulse transmission channel 150 (situation 4), an in-rush current appears along the circuit: the power supply input 153 - the third resistor 803 - the second transistor 880 - the first transistor 870 - the first resistor 801 - the input 151 of the control pulse transmission channel 150. Also, due to the effect of the current mirror, a pulse interference current flows as well through the fourth resistor 804 and the third transistor 890 creating an additional voltage drop across the second resistor 802. This voltage drop passes to the output 159 as the output signal comprising the pulse interference.

So, always present at the output 159 of the control pulse transmission channel 150 during the control pulse IN is the output control pulse (situation 1), to which an interference pulse is added if a high-intensity pulse interference appears (situation 2). When there is no control pulse IN, there is no output control pulse at the output 159 of the control pulse transmission channel 150 (situation 3), but when the high-intensity pulse interference is present, the interference pulse appears at the output 159 (situation 4).

The interference transmission channel 130 operates similarly to the control pulse transmission channel 150, but with the following peculiarities:

1) The control pulse does not come to the interference transmission channel 130, but it has the fourth transistor 9010 (permanently closed due to the connection of the second (control) electrode and the third electrode) and similar to the transistor 350 of the switch 140.

Therefore the parameters of the circuit in the interference transmission circuit 130: the power supply input 133 - the third resistor 903 - the second transistor 980 - the first transistor 970 - the first resistor 901 - the fourth transistor 9010 are similar to the respective circuit in the control pulse transmission channel 150 (and taking into account the transistor 350) except that no current flows along this circuit during both the presence and absence of the control pulse. No current flows respectively along the following circuit: the power supply input 133 - the fourth resistor 904 - the third transistor 990 - the second resistor 902 - the terminal 137 of the interference transmission channel 130. Therefore, the output pulse of the interference transmission channel 130 does not appear at the output 139 either during the presence of the control pulse IN or when it is absent.

2) When a high-intensity pulse interference appears at terminal 137 of the interference transmission channel 130, the channel130 operates similarly to the control pulse transmission channel 150, and the interference pulse is always present at the output 139 of the interference transmission channel 130 when the high-intensity pulse interference comes.

So, the control pulse is always absent at the output 139 of the interference transmission channel 130, whereas the interference pulse appears if and only if the high-intensity pulse interference appears at terminal 137.

Since channel 130 of control pulse transmission and 150 of interference pulse transmission are carried out similarly (taking into account the transistor 350), high degree of similarity is achieved in the interference pulses coming to the inputs 171 and 175 of the interference suppression circuit 170a.

From the output 159 of the control pulse transmission channel 150, the output control pulse in the situation 1, or the output control pulse and the interference pulse in the situation 2, come to the first input 171 of the interference suppression circuit 170a which is connected to the third electrode of the transistor 570.

In situations 2 and 4, the interference pulse comes from the output 139 of the interference transmission channel 130 to the second input 175 of the interference suppression circuit 170a.

When both the control pulse and the high-intensity pulse interference are simultaneously present at the inputs 171 and 175 (at the third electrode and the second (control) electrode of the transistor 570, respectively), there takes place subtraction of the pulse interference at these inputs, and the difference positive signal of the set amplitude appears on the resistor 510 of the interference suppression circuit 170a which is connected with the first electrode 577 of the transistor 570, the difference signal passing to the output 179 of the interference suppression circuit 170a.

If the high-intensity pulse interference appears in the absence of the control pulse, the voltages at the third electrode and at the second, control, electrode of the transistor 570 are equal, and formed at the resistor 510, which is connected to the first electrode 577 of the transistor 570, is a zero difference signal passing to the output 179 of the interference suppression circuit 170a.

Thus, if the control pulse is present at the input 171 of the interference suppression circuit 170a (the situations 1 or 2), the difference signal as a positive pulse is formed at the output 179 thereof whether the high-intensity pulse interference is present or not, whereas if the control pulse is absent at the input 171 of the interference suppression circuit 170a (situations 3 or 4), the zero difference signal is formed at the output 179 thereof whether the high-intensity pulse interference is present or not.

The difference signal comes from the output 179 of the interference suppression circuit 170a to the input 181 of the output stage 180 comprising the Schmidt trigger 650 converting the analog input signal into the digital output one. From the output 189 of the output stage 180, the output digital signal (representing the pulse controlling the upper transistor of the power switch) proceeds to the output 105 of the claimed LSC having sufficiently sharp edges to switch on the upper-level transistor 7a of the power switch (shown in Fig. 10a and is not a part of the LSC).

In this way, the claimed apparatus according to the first embodiment thereof simultaneously provides compensation of high-intensity pulse interferences having high rise rate (because of subtraction of interferences passing through identical transmission channels 150 and 130 for control pulse and interference, respectively) and moderate power consumption in the normal mode of operation (due to the capability to set the current flowing through the current generator 120, the switch 140, and the control pulse transmission channel 150 at the extremely low level (the very few milliamperes, for example)) that provides achieving of the declared technical result.

The claimed LSC, in one of possible implementations thereof shown in Fig. 10b, which presents the elements disclosed in Figs. 3, 4, 5a, 6, 7b, 8, and 9 according to the second embodiment of the proposed apparatus, operates as follows.

When the control pulse IN comes to the control input 102 of the LSC 100b and further appears at the second, control, terminal 145 of the switch 140, the transistor 340 closes, and the resistance between the first and the third electrodes thereof becomes very high. The transistor 350 at the same time is open due to the potential $V_{cc}$ at the low-voltage power supply input 143 of the switch 140 passing via the resistor 360 to the second (control) electrode of the transistor 340. Hence, the current flows via the transistor 350 (and therefore via the switch 140) along the following circuit: the terminal 104 of the LSC 100b, serving for connecting of floating upper-level high-voltage power supply - the power supply input 153 of the control pulse transmission channel 150 - the third resistor 803, the second transistor 880, the first transistor 870, and the first resistor 801 of the control pulse transmission channel 150 - the transistor 350 of the switch 140 - the transistor 740 of the controllable current generator 1120 - the first terminal 127 of the controllable current generator 1120 - the terminal 103 of the LSC 100b serving for connecting to the common wire of the LSC. The circuit closes due to the connection of that common wire of the LSC with the source of the transistor 7b and the negative pole of the high-voltage power supply source 6 shown in Fig. 10b but not being parts of the LSC 100b.

After the control pulse IN ends, the transistor 340 of the switch 140 opens, the resistance between the first electrode (drain) and the third electrode (source) becomes low, and the potential difference between the second, control, electrode (gate) and the third electrode of the transistor 350 of the switch 140 becomes close to zero. Therefore, the transistor 350 closes, the switch 140 is now open, and the above-described current flowing circuit is also open.

Having the transistor 340 in the switch 140 accelerates the process of closing of the switch because the small resistance of the opening transistor 340 shunts high input capacity of the transistor 350, and the total operation speed of the LSC 100b increases.

The value of $I_0$, flowing during the control pulse IN is defined by the controllable current generator 1120:

$$I_0 = (V_{cc} - V_d) / R_{112},$$

where $V_{cc}$ - low-voltage power supply coming to the first terminal 101 of the LSC 100b from the low-voltage power supply source 5 not included in the LSC 100b, $V_d$ - voltage between the second (control) and the third electrodes of the transistor 730 of the controllable current generator 1120, and $R_{112}$ - resistance of the resistor 112 of the current setter 110.

The value of the low-voltage power supply $V_{cc}$ can be within 4.5...5.5 V relative to the potential of the common wire of the circuit, whereas the value of $I_0$ is set using the current setter 110 at the extremely low level (the very few milliamperes, for example) to lower power consumption.

When the control pulse IN arrives from the pulse input of the controllable current generator 1120 to the driven multivibrator 710, a short pulse is generated at the multivibrator output, the length of the pulse being a fraction of a percent of the duration of the pulse IN. This pulse opens the third transistor 720 which connects the third resistor 760 in parallel to the second resistor 770 of the controllable current generator 1120. Usually, the resistance of the third resistor 760 is selected 5...15 times less than that of the second resistor 770, therefore the current through the controllable current generator 1120 increases at about the same ratio reaching the level of $I_1=5...15\ I_0$. Upon completion of the short pulse at the output of the driven multivibrator 710, the third transistor 710 closes, and the third resistor 760 becomes disconnected from the first terminal 127 of the controllable current generator 1120. Therefore, during the rest of the duration of the control pulse IN, the current $I_0$ flows through the controllable current generator 1120.

The surge suppression circuit 160 is used for preventing the breakdown of the input barrier of the transistor 350 of the switch 140 which can result in failure both the transistor 350 and the whole LSC 100b. The breakdown can happen at the moment of the leading front of the control pulse IN when a voltage surge occurs at the first electrode of the transistor 350 and passes to the third electrode of the transistor 350 of the switch 140 via the cross capacitance of this transistor.

The surge suppression circuit 160 operates as follows.

The control pulse IN comes from the control input 102 of the LSC 100b to the second (control) input 165 connected to the second electrode of the transistor 460 and opens the transistor. As the anode of the Zener diode 430 via the second terminal 169 of the surge suppression circuit 160 and the first terminal 147 of the switch 140 is connected to the third electrode of the transistor 350 of the switch 140, the potential of the third electrode of the transistor 350 is equal at this moment to the voltage at the anode of the Zener diode 430. This voltage comprises the voltage at the open transistor 460 and the voltage stabilizing the Zener diode 430 and amounts to a few volts. The voltage at the second (control) electrode of the transistor 350 is equal to the potential $V_{cc}$ of the low-voltage power supply source 5 at the low-voltage power supply input 143 of the switch 140, the potential difference between the second, control, electrode of the transistor 350 and the anode of the Zener diode 430 is rather small, and, therefore, the breakdown of the input barrier of the transistor 350 in light of this is impossible.

As the control pulse IN ends, the transistor 460 closes, cutting the Zener diode 460 off the first terminal 167 of the surge suppression circuit 160 and thus prevents the Zener diode 460 from failure because of the potential $V_{cc}$ of the low-voltage power supply source 5 coming to the anode of the Zener diode 430 from the low-voltage power supply input 143 of the switch 140 via the short-circuited transistor 340.

The control pulse transmission channel 150 (see Fig. 8) operates as follows.

Generated at the output 159 of the control pulse transmission channel 150 during the control pulse IN and in the absence of the interference (situation 1) is a pulse of the positive polarity relative to the voltage $V_s$ at terminal

106 of the LSC 100b passing to the first input 171 of the interference suppression circuit 170.

The pulse is generated in the following way: when the control pulse IN appears at the control input 102 of the LSC 100b and passes to the second, control, terminal 145 of the switch 140, the latter closes and thus creates a circuit for the current flowing from the power supply input 153 of the control pulse transmission channel 150 to the first terminal 127 of the controllable current generator 1120.

This current flows in the control pulse transmission channel 150 along the following circuit: the power supply input 153 - the third resistor 803 - the second transistor 880 - the first transistor 870 - the first resistor 801 - the input 151.

The first transistor 870 is open by the voltage of the DC voltage source 8030 when the control pulse IN is present and serves a buffer stage ensuring sufficient operation speed of the circuit under consideration.

The pair of transistors - the second, 880, and the third, 890, forms a current mirror, therefore as the current flows through the second transistor 880, a current flows through the third transistor 890 as well. The value of this current is defined by the nominal ratio of the third resistor 803 and the fourth resistor 804. This current creates a voltage drop across resistor 802 which passes to the terminal 159 as an output pulse of the control pulse transmission channel 150, the amplitude of the pulse exceeds the potential $V_s$ of the terminal 157 by a prescribed value.

If, during the presence of the control pulse IN, a high-intensity pulse interference appears at the terminal 157 of the control pulse transmission channel 150 (situation 2), an in-rush current appears along the circuit: the power supply input 153 - the third resistor 803 - the second transistor 880 - the first transistor 870 - the first resistor 801 - the input 151 of the control pulse transmission channel 150. At the same time, due to the effect of the current mirror, a pulse interference current flows through the fourth resistor 804 and the third transistor 890 as well and creates an additional voltage drop across the second resistor 802. This voltage drop is added to the voltage of the output pulse of the control pulse transmission channel 150 and passes to the output 159 as the output signal comprising the sum of the control pulse and the high-intensity pulse interference.

Where there is no control pulse IN at the control input 102 of the LSC 100b (situation 3), the switch 140 cuts the circuit of the current flowing between the power supply input 153 and the input 151 of the control pulse transmission channel 150. Similarly, the current does not flow through the fourth resistor 804 - the third transistor 890 - the second resistor 802, and there is no output pulse of the control pulse transmission channel 150.

If, during the absence of the control pulse a high-intensity pulse interference appears at the terminal 157 of the control pulse transmission channel 150 (situation 4), an in-rush current appears along the circuit: the power supply input 153 - the third resistor 803 - the second transistor 880 - the first transistor 870 - the first resistor 801 - the input 151 of the control pulse transmission channel 150. Also, due to the effect of the current mirror, a pulse interference current flows as well through the fourth resistor 804 and the third transistor 890 creating an additional voltage drop across the second resistor 802. This voltage drop passes to the output 159 as the output signal comprising the pulse interference.

So, always present at the output 159 of the control pulse transmission channel 150 during the control pulse IN is the output control pulse (situation 1), to which an interference pulse is added if a high-intensity pulse interference appears (situation 2). When there is no control pulse IN, there is no output control pulse at the output 159 of the control pulse transmission channel 150 (situation 3), but when the high-intensity pulse interference is present, the interference pulse appears at the output 159 (situation 4).

The interference transmission channel 130 operates similarly to the control pulse transmission channel 150, having, however, the following peculiarities:

1) The control pulse does not come to the interference transmission channel 130, but it has the fourth transistor 9010 (permanently closed due to the connection of the second (control) electrode and the third electrode thereof) similar to the transistor 350 of the switch 140.

Therefore the parameters of the circuit in the interference transmission circuit 130: the power supply input 133 - the third resistor 903 - the second transistor 980 - the first transistor 970 - the first resistor 901 - the fourth transistor 9010 are similar to the respective circuit in the control pulse transmission channel 150 (and taking into account the transistor 350) except that no current flows along this circuit during both the presence and absence of the control pulse. No current flows respectively along the following circuit: the power supply input 133 - the fourth resistor 904 - the third transistor 990 - the second resistor 902 - the terminal 137 of the interference transmission channel 130. Therefore, the output pulse of the interference transmission channel 130 does not appear at the output 139 either during the presence of the control pulse IN or when it is absent.

2) When a high-intensity pulse interference appears at terminal 137 of the interference transmission channel 130, the channel 130 operates similarly to the control pulse transmission channel 150, and the interference pulse is always present at the output 139 of the interference transmission channel 130 when the high-intensity pulse interference comes.

So, the control pulse is always absent at the output 139 of the interference transmission channel 130, whereas the interference pulse appears if and only if the high-intensity pulse interference appears at terminal 137.

Since channels 150 of control pulse transmission and 130 of interference transmission are carried out similarly (taking into account the transistor 350), high degree of similarity is achieved in the interference pulses coming to the inputs 171 and 175 of the interference suppression circuit 170a.

From the output 159 of the control pulse transmission channel 150, the output control pulse in the situation 1, or the output control pulse and the interference pulse in the situation 2, come to the first input 171 of the interference suppression circuit 170a which is connected to the third electrode of the transistor 570.

In the situations 2 and 4, the interference pulse comes from the output 139 of the interference transmission channel 130 to the second input 175 of the interference suppression circuit 170a.

When both the control pulse and the high-intensity pulse interference are simultaneously present at the inputs 171 and 175 (at the third electrode and the second (control) electrode of the transistor 570, respectively), there takes place subtraction of the pulse interference at these inputs, and the difference positive signal of the set amplitude appears on the resistor 510 of the interference suppression circuit 170a which is connected with the first electrode 577 of the transistor 570, the difference signal passing to the output 179 of the interference suppression circuit 170a.

If the high-intensity pulse interference appears in the absence of the control pulse, the voltages at the third electrode and at the second, control, electrode of the transistor 570 are equal, and formed at the resistor 510, which is connected to the first electrode 577 of the transistor 570, is a zero difference signal passing to the output 179 of the interference suppression circuit 170a.

Thus, if the control pulse is present at the input 171 of the interference suppression circuit 170a (the situations 1 or 2), the difference signal as a positive pulse is formed at the output 179 thereof whether the high-intensity pulse interference is present or not, whereas if the control pulse is absent at the input 171 of the interference suppression circuit 170a (situations 3 or 4), the zero difference signal is formed at the output 179 thereof whether the high-intensity pulse interference is present or not.

The difference signal comes from the output 179 of the interference suppression circuit 170a to the input 181 of the output stage 180 comprising the Schmidt trigger 650 converting the analog input signal into the digital output one. From the output 189 of the output stage 180, the output digital signal (representing the pulse controlling the upper transistor of the power switch) proceeds to the output 105 of the claimed LSC having sufficiently sharp edges to switch on the upper-level transistor 7a of the power switch (shown in Fig. 10b and is not a part of the LSC).

In this way, the claimed apparatus according to the second embodiment thereof simultaneously provides compensation of high-intensity pulse interferences having high rise rate (because of subtraction of interferences passing through identical transmission channels 150 and 130 for control pulse and interference, respectively) and moderate power consumption in the normal mode of operation (due to the capability to set the current flowing through the controllable current generator 1120, the switch 140, and the control pulse transmission channel 150 at the extremely low level (the very few milliamperes, for example)) that provides achieving of the declared technical result. Also, the LSC is characterized, according to the second embodiment, by improved operation speed due to short time rise of the current flowing through the controllable current generator 1120, the switch 140, and the control pulse transmission channel 150 in the beginning of the control pulse IN.

It is clear to those skilled in the art that various versions of implementation of the elements of the claimed LSC are possible.

For example, DC voltage sources 8030 (9030) in the channels 150 and 130 of transmission of, respectively, control pulse and interference (see Figs. 8 and 9) can be realized as voltage dividers connected to the floating low-voltage power supply source 8 via the terminal 104 of the apparatus (see Figs. 2a, 2b), or as a series connection of a resistor and a Zener diode, or in any other way ensuring generating required voltage.

The current generator 120 and the controllable current generator 1120 can be realized not only as shown in Figs. 7a, b, but also in other known way, such as, for example, the circuit disclosed in R.J. Widlar, US patent 3,320,439 of May 16, 1967.

The apparatus presented in Figs. 2a, 2b can be realized using standard electronic components such as diodes, transistors, and resistors, or integrated circuits (IC) including custom-designed IC. So, n-channel FET with maximum drain-source voltage 20V, drain current no less than 20 mA, and pulse current no less than 0.5 A, such as DMN26DOUT, can be used in the current generator 120.

The transistors 355 and 9010 (shown in Figs. 3, 9) should have maximum drain-source voltage no less than 600 V and drain-source capacitance no more than 5 pF at the voltage 500V. In this capacity transistors BSS225 can be used.

Instead of FET disclosed in the specification and shown in the drawings, bipolar transistors can be used. It particularly relates to transistor pairs 520-530, 730-740, and 880-890 used for current mirrors in current generators 120 and 1120, control pulse transmission channel 150, and interference transmission channel 130.

A comparator, such as LT1719, can be used for the interference suppression circuit 170. The output stage 180, shown in Fig.6, can be realized using microchip UCC27511DBV that has power supply voltage 4.5 ... 18 V, outgoing current 4 A, incoming current 8 A, on/off delay 13 ns, or microchip SN74LVC1G1 using power supply voltage 1.65 ... 5.5 V, outgoing/incoming current 24 mA, and on/off delay 1 ns.

Nominal values of resistors 803 (903) and 804 (904) of the control pulse transmission channel 150 (Fig. 8) and the interference transmission channel 130 (Fig. 9) can be within 100 ... 200 Ohm and 200 .. 300 Ohm, respectively.

The other elements of the LSC 100 can be realized by any way known in the art which results in achieving the declared technical result.

The claimed LSC can be made, for example, as a microchip, a micro assembly, or a micro board, the preferable way being a microchip which allows to minimize space and lower manufacturing expenses.

Also, the claimed LSC can be a part of other structures or other microchips, micro assemblies, or a micro boards. Portions of some elements mentioned in the disclosure can differ, partially coincide, or completely coincide with portions of other elements unless the contrary is expressly indicated. Additionally, parts of some elements can be placed in various portions of the other elements, unless the contrary is expressly indicated.

**Experimental results**

In order to confirm achievability of the declared technical result, scale modeling of the second embodiment of the LSC for controlling a power switch was performed and the following results were obtained: Interference rise rate dV/dt no less than 100 V/ns.

Power consumption - no more than 600 mW at the control frequency 100 kHz and duty cycle 2.

High-voltage power supply no less 500 V.

On-off delays are 130/180 ns respectively.

It follows from the above description and the attached drawings that the technical result achieved by the claimed design really lies in proposing a LSC having increased interference immunity and insignificant power dissipation at high-voltage power supply of the upper transistor of the power switch.

The claimed invention, however, is not limited by what is disclosed above. It is described based on what is now considered practical implementation of various embodiments thereof. It should be understood that the claimed invention is not limited by the disclosed embodiments, but in contrast is intended for use in various modifications and equivalent implementations corresponding to suggestions and spirit of the below claims.

Accordingly, the description and drawings are illustrative and do not limit the invention realization possibilities.

The proposed technology is defined by the following claims.

**Claims**

1. A level shift circuit (100a) for controlling a power switch, the circuit comprising a current generator (120) and a switch (140), a second terminal (129) of the current generator (120) being connected to a first terminal (147) of the switch (140), whereas a second, control, terminal (145) of the switch (140) being connected to an input (102) of the level shift circuit (100a) , **characterized by** that the level shift circuit (100a) further comprises an interference transmission channel (130), a control pulse transmission channel (150), an interference suppression circuit (170) generating an output signal of the level shift circuit (100a) for controlling the power switch, a third terminal (149) of the switch (140) being connected to an input (151) of the control pulse transmission channel (150), a first input (171) of the interference suppression circuit (170) being connected to an output (159) of the control pulse transmission channel (150), and a second input (175) of the interference suppression circuit (170) being connected to an output (139) of the interference transmission channel (130).

2. The level shift circuit (100a) as claimed in claim 1, **characterized by** that the control pulse transmission channel (150) comprises a first transistor (870), a second transistor (880) which forms a current mirror with a third transistor (890), a low-voltage power supply source (8030), a first resistor (801), a second resistor (802), a third resistor (803), a fourth resistor (804), and wherein the input (151) of the control pulse transmission channel (150) is connected to the first resistor (801) which is connected in series successively with the first transistor (870), the second transistor (880), and the third resistor (803) connected to a power supply input (153) of the control pulse transmission channel (150), connected to a terminal 157 of the control pulse transmission channel (150) is the second resistor (802) which is connected in series successively with the third transistor (890) and the fourth resistor (804) also connected to a power supply input (153) of the control pulse transmission channel (150), also connected to the terminal (157) of the control pulse transmission channel (150) is the negative pole of the low-voltage power supply source (8030), the positive pole thereof being connected to a second, control, electrode of the first transistor (870), whereas second, control, electrodes of the second transistor (880) and the third transistor (890) are connected to each other, to a first electrode of the first transistor (870) and to a third electrode of the second transistor (880), and a joining point of a first electrode of the third transistor (890) and the second resistor (802) is connected to the output (159) of the control pulse transmission channel (150).

3. The level shift circuit (100a) as claimed in claim 1, **characterized by** that the interference transmission channel (130) comprises a first transistor (970), a second transistor (980) which forms a current mirror with a third transistor (990), a fourth transistor (9010), a low-voltage power supply source (9030), a first resistor (901), a second resistor (902), a third resistor (903), and a fourth resistor (904), and by that a low-voltage power supply input (135) of the interference transmission channel (130) is connected to a series connection of the fourth transistor (9010), the first resistor (901), the first transistor (970), the second transistor (980), and the third resistor (903) connected to a high-voltage power supply input (133) of the interference transmission channel (130), connected to a terminal (137) of the interference transmission channel (130) is a series connection of the second resistor (902), the third transistor (990) and the fourth resistor (904), the latter being also connected to the high-voltage power supply input (133) of the interference transmission channel (130), the terminal (137) of the interference transmission channel (130) being also connected to a negative pole of the low-voltage power supply source (9030), a positive pole thereof being connected to a second, control, electrode of the first transistor (970), second, control, electrodes of the second transistor (980) and the third transistor (990) are connected to each other and with a first electrode of the first transistor (970) and to a third electrode of the second transistor (980), a joining point of a first electrode of the third transistor (980) and the second resistor (902) is connected to an output (139) of the interference transmission channel (130), and a second, control, electrode of the fourth transistor (9010) is connected to a third electrode thereof.

4. The level shift circuit (100a) as claimed in claim 1, **characterized by** that the interference suppression circuit (170) comprises a transistor (570) and a resistor (510), a third electrode (571) of the transistor (570) is connected to a first input (171) of the interference suppression circuit (170), a second, control, electrode (575) of the transistor (570) is connected to a second input (175) of the interference suppression circuit (170), a first electrode (577) of the transistor (570) is connected to an output (179) of the interference suppression circuit (170), and the resistor (510) is connected between the output (179) and a terminal (177) of the interference suppression circuit (170).

5. The level shift circuit (100a) as claimed in claim 1, **characterized by** that the interference suppression circuit (170) comprises a first transistor (570), a second transistor (520), a third transistor (530), and a resistor (510), a first input (171) of the interference suppression circuit (170) is connected to a third electrode (571) of the first transistor (570), a second input (175) of the interference suppression circuit (170) is connected to a second, control, electrode (575) of the first transistor (570), a first electrode (577) of the first transistor (570) is connected to a first electrode (527) of the second transistor (520) and to a joining point of a second, control, electrode (525) of the second transistor (520) and a second, control, electrode (535) of the third transistor (530), a third electrode (521) of the second transistor (520) and a third electrode (531) of the third transistor (530) are connected to each other and to a power supply input (173) of the interference suppression circuit (170), and an output (179) of the interference suppression circuit (170) is connected to a first electrode (537) of the third transistor (530) and with a first terminal (511) of the resistor (510), a second terminal (513) thereof being connected to a terminal (177) of the interference suppression circuit (170).

6. The level shift circuit (100a) as claimed in claim 1, **characterized by** that it comprises an output stage (180), an input (181) thereof being connected to an output (179) of the interference suppression circuit (170) and an output (189) thereof being an output of the level shift circuit (100a).

7. The level shift circuit (100a) as claimed in claim 6, **characterized by** that the output stage (180) comprises a Schmidt trigger (650), the input (181) of the output stage being connected to an input (651) of the Schmidt trigger (650), an output (655) of the Schmidt trigger (650) being connected to the output (189) of the output stage (180), a power supply input (652) of the Schmidt trigger (650) being connected with a power supply input (183) of the output stage (180), and a terminal (654) of the Schmidt trigger (650), serving for connecting to a common wire, being connected to a terminal (187) of the output stage (180).

8. The level shift circuit (100a) as claimed in claim 1, **characterized by** that the current generator (120) comprises a first transistor (730) and a second transistor (740), a first electrode (733) of the first transistor (730) and a joining point of a second, control, electrode (735) of the first transistor (730) and of a second, control, electrode (745) of the second transistor (740) being connected to a control input (126) of the current generator (120), a first electrode (743) of the second transistor (740) being connected to a second terminal (129) of the current generator (120), and a third electrode (737) of the first transistor (730) and a third electrode (747) of the second transistor (740) being connected to each other and to a first terminal (127) of the current generator (120).

9. The level shift circuit (100a) as claimed in claim 1, **characterized by** that the switch (140) comprises a first transistor (340), a second transistor (350) and a resistor (360), a first terminal (365) of the resistor (360) being connected to a low-voltage power supply input (143) of the switch (140), a second, control, electrode (345) of the first transistor (340) being connected to a second, control, terminal (145) of the switch (140), a second, control, electrode (355) of the second transistor (350) being connected to a second terminal (367) of the resistor (360) and to a third electrode (347) of the first transistor (340), a first electrode (343) of the first transistor (340) and a third electrode (357) of the second transistor (350) being connected to a first terminal (147) of the switch (140), and a first electrode (353) of the second transistor (350) being connected to a third terminal (149) of the switch (140).

10. The level shift circuit (100a) as claimed in claim 1, **characterized by** that it further comprises a surge suppression circuit (160) connected in parallel to the current generator (120) and comprising a transistor (460) and a Zener diode (430), a second, control, electrode (465) of the transistor (460) being connected to a second, control, input (165) of the surge suppression circuit (160), an anode (432) of the Zener diode (430) being connected to a first electrode (463) of the transistor (460), a cathode (435) of the Zener diode (430) being connected to a first terminal (169) of the surge suppression circuit (160), and a third electrode (467) of the transistor (460) being connected to a second terminal (167) of the surge suppression circuit (160).

11. A level shift circuit (100b) for controlling a power switch, the circuit comprising a switch (140), a second, control, terminal of the switch (140) being connected to an input (102) of the level shift circuit (100b), **characterized by** that the level shift circuit (100b) further comprises a controllable current generator (1120), a control pulse transmission channel (150), an interference transmission channel (130), and an interference suppression circuit (170) generating an output signal of the level shift circuit (100b) for controlling the power switch, a second terminal 129 of the controllable current generator 1120 being connected to a first terminal (147) of the switch 140, a third terminal (149) of the switch 140 being connected to an input (151) of the control pulse transmission channel (150), a first input (171) of the interference suppression circuit (170) being connected to an output (159) of the control pulse transmission channel (150), a second input (175) of the interference suppression circuit (170) being connected to an output (139) of the interference transmission channel (130), and a pulse input (1125) of the controllable current generator (1120) being connected to the input (102) of the level shift circuit (100b).

12. The level shift circuit (100b) as claimed in claim 11, **characterized by** that the control pulse transmission channel (150) comprises a first transistor (870), a second transistor (880) which forms a current mirror with a third transistor (890), a low-voltage power supply source (8030), a first resistor (801), a second resistor (802), a third resistor (803), a fourth resistor (804), and wherein the input (151) of the control pulse transmission channel (150) is connected to the first resistor (801) which is connected in series successively with the first transistor (870), the second transistor (880), and the third resistor (803) connected to a power supply input (153) of the control pulse transmission channel (150), connected to a terminal 157 of the control pulse transmission channel (150) is the second resistor (802) which is connected in series successively with the third transistor (890) and the fourth resistor (804) also connected to a power supply input (153) of the control pulse transmission channel (150), also connected to the terminal (157) of the control pulse transmission channel (150) is the negative pole of the low-voltage power supply source (8030), the positive pole thereof being connected to a second, control, electrode of the first transistor (870), whereas second, control, electrodes of the second transistor (880) and the third transistor (890) are connected to each other, to a first electrode of the first transistor (870) and to a third electrode of the second transistor (880), and a joining point of a first electrode of the third transistor (890) and the second resistor (802) is connected to the output (159) of the control pulse transmission channel (150).

13. The level shift circuit (100b) as claimed in claim 11, **characterized by** that the interference transmission channel (130) comprises a first transistor (970), a second transistor (980) which forms a current mirror with a third transistor (990), a fourth transistor (9010), a low-voltage power supply source (9030), a first resistor (901), a second resistor (902), a third resistor (903), and a fourth resistor (904), and by that a low-voltage power supply input (135) of the interference transmission channel (130) is connected to a series connection of the fourth transistor (9010), the first resistor (901), the first transistor (970), the second transistor (980), and the third resistor (903) connected to a high-voltage power supply input (133) of the interference transmission channel (130), connected to a terminal (137) of the interference transmission channel (130) is a series connection of the second resistor (902), the third transistor (990) and the fourth resistor (904), the latter being also connected to the high-voltage power supply input (133) of the interference transmission channel (130), the terminal (137) of the interference transmission channel (130) being also connected to a negative pole of the low-voltage power supply source (9030), a positive pole thereof being connected to a second, control, electrode of the first transistor (970), second, control, electrodes of the second transistor (980) and the third transistor (990) are connected to each other and with a first electrode of the first transistor (970) and to a third electrode of the second transistor (980), a joining point of a first electrode of the third transistor (980) and the second resistor (902) is connected to an output (139) of the interference transmission channel (130), and a second, control, electrode of the fourth transistor (9010) is connected to a third electrode thereof.

14. The level shift circuit (100b) as claimed in claim 11, **characterized by** that the interference suppression circuit (170) comprises a transistor (570) and a resistor (510), a third electrode (571) of the transistor (570) is connected to a first input (171) of the interference suppression circuit (170), a second, control, electrode (575) of the transistor (570) is connected to a second input (175) of the interference suppression circuit (170), a first electrode (577) of the transistor (570) is connected to an output (179) of the interference suppression circuit (170), and the resistor (510) is connected between the output (179) and a terminal (177) of the interference suppression circuit (170).

15. The level shift circuit (100b) as claimed in claim 11, **characterized by** that the interference suppression circuit (170) comprises a first transistor (570), a second transistor (520), a third transistor (530), and a resistor (510), a first input (171) of the interference suppression circuit (170) is connected to a third electrode (571) of the first transistor (570), a second input (175) of the interference suppression circuit (170) is connected to a second, control, electrode (575) of the first transistor (570), a first electrode (577) of the first transistor (570) is connected to a first electrode (527) of the second transistor (520) and to a joining point of a second, control, electrode (525) of the second transistor (520) and a second, control, electrode (535) of the third transistor (530), a third electrode (521) of the second transistor (520) and a third electrode (531) of the third transistor (530) are connected to each other and to a power supply input (173) of the interference suppression circuit (170), and an output (179) of the interference suppression circuit (170) is connected to a first electrode (537) of the third transistor (530) and with a first terminal (511) of the resistor (510), a second terminal (513) thereof being connected to a terminal (177) of the interference suppression circuit (170).

16. The level shift circuit (100b) as claimed in claim 11, **characterized by** that it comprises an output stage (180), an input (181) thereof being connected to an output (179) of the interference suppression circuit (170) and an output (189) thereof being an output of the level shift circuit (100b).

17. The level shift circuit (100b) as claimed in claim 16, **characterized by** that the output stage (180) comprises a Schmidt trigger (650), the input (181) of the output stage being connected to an input (651) of the Schmidt trigger (650), an output (655) of the Schmidt trigger (650) being connected to the output (189) of the output stage (180), a power supply input (652) of the Schmidt trigger (650) being connected with a power supply input (183) of the output stage (180), and a terminal (654) of the Schmidt trigger (650), serving for connecting to a common wire, being connected to a terminal (187) of the output stage (180).

18. The level shift circuit (100b) as claimed in claim 11, **characterized by** that the controllable current generator (1120) comprises a first transistor (730), a second transistor (740), a third transistor (720), a driven multivibrator (710), a first (750), a second (770), and a third (760) resistors, a first electrode (733) of the first transistor (730) and a joining point of a second, control, electrode (735) of the first transistor (730) and a second, control, electrode (745) of the second transistor (740) being connected to a control input (126) of the controllable current generator (1120), a first electrode (743) of the second transistor (740) being connected to a second terminal (129) of the controllable current generator (1120), a third electrode (737) of the first transistor (730) being connected to a first terminal (127) of the controllable current generator (1120) via the first resistor (750), a third electrode (747) of the second transistor (740) being connected to the first terminal (127) via the second resistor (770), a terminal (763) of the third resistor (760) being connected to a common point of the third electrode)of the second transistor (740) and the second resistor (770), a terminal (761) of the third resistor (760) being connected to a first electrode (723) of the third transistor (720), a second, control, electrode (725) of the third transistor (720) being connected to an output (719) of the driven multivibrator (710), a third electrode (727) of the third transistor (720) being connected to a first terminal (127) of the controllable current generator (1120), and an input (711) of the driven multivibrator (710) being connected to a pulse input (1125) of the controllable current generator (1120).

19. The level shift circuit (100b) as claimed in claim 11, **characterized by** that the switch (140) comprises a first transistor (340), a second transistor (350) and a resistor (360), a first terminal (365) of the resistor (360) being connected to a low-voltage power supply input (143) of the switch (140), a second, control, electrode (345) of the first transistor (340) being connected to a second, control, terminal (145) of the switch (140), a second, control, electrode (355) of the second transistor (350) being connected to a second terminal (367) of the resistor (360) and to a third electrode (347) of the first transistor (340), a first electrode (343) of the first transistor (340) and a third electrode (357) of the second transistor (350) being connected to a first terminal (147) of the switch (140), and a first electrode (353) of the second transistor (350) being connected to a third terminal (149) of the switch (140).

20. The level shift circuit (100b) as claimed in claim 11, **characterized by** that it further comprises a surge suppression circuit (160) connected in parallel to the controllable current generator (1120) and comprising a transistor (460) and a Zener diode (430), a second, control, electrode (465) of the transistor (460) being connected to a second, control, input (165) of the surge suppression circuit (160), an anode (432) of the Zener diode (430) being connected to a first electrode (463) of the transistor (460), a cathode (435) of the Zener diode (430) being connected to a first terminal (169) of the surge suppression circuit (160), and a third electrode (467) of the transistor (460) being connected to a second terminal (167) of the surge suppression circuit (160).

PRIOR ART

Fig.1

Fig.2a

Fig.2b

Fig.3

Fig.4

Fig.5a

Fig.5b

Fig.6

Fig.7a

Fig.7b

Fig.8

Fig.9

Fig.10a

Fig.10b

## INTERNATIONAL SEARCH REPORT

| | International application No. |
|---|---|
| | PCT/RU 2023/000196 |

| A. CLASSIFICATION OF SUBJECT MATTER |
|---|
| H03K 19/0185 (2006.01 ), H03K 3/356 (2006.01), H03K 17/687 (2006.01), H03K 3/013 (2006.01) |
| According to International Patent Classification (IPC) or to both national classification and IPC |

| B. FIELDS SEARCHED |
|---|
| Minimum documentation searched (classification system followed by classification symbols) |
| H03K 3/00, 3/01, 3/013, 3/027, 3/037, 3/26, 3/28, 3/353, 3/356, 17/00, 17/51, 17/56, 17/60, 17/687, 19/00, 19/01, 19/0185 |
| Documentation searched other than minimum documentation to the extent that such documents are included in the fields searched |
| |
| Electronic data base consulted during the international search (name of data base and, where practicable, search terms used) |
| Espacenet, Patsearch, PATENTSCOPE |

| C. DOCUMENTS CONSIDERED TO BE RELEVANT | | |
|---|---|---|
| Category* | Citation of document, with indication, where appropriate, of the relevant passages | Relevant to claim No. |
| A,D | US 2015/358003 AI (SHARP KUSHIKI KAISHA) 10.12.2015 | 1-20 |
| A | US 8405422 B2 (FUJI ELECTRIC CO, LTD) 26.03.2013 | 1-20 |
| A | CN113193865A (UNIV ELECTRONIC SCI & TECH CHINA) 30.07.2021 | 1-20 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 October 2023 (27.10.2023) | 02 April 2024 (02.04.2024) |

| Name and mailing address of the ISA/ RU: | Authorized officer |
|---|---|
| | |
| Facsimile No. | Telephone No. |

Form PCT/ISA/210 (second sheet) (July 1998)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9564882 B
- US 9264022 B
- US 9564882 B2
- US 3320439 A

**Non-patent literature cited in the description**

- Current Limiting Single Channel Driver. *IR2125(S) & (PbF) Data Sheet No. PD60017 Rev.Q*, 12 September 2004
- *ON Semiconductor FAN7083-GF085 High Side Gate Driver with Reset*, September 2017